# EUROPÄISCHE PATENTSCHRIFT

(11) **EP 3 769 421 B1**
(45) Veröffentlichungstag und Bekanntmachung des Hinweises auf die Patenterteilung: **27.08.2025**
(21) Anmeldenummer: 19708095.5
(22) Anmeldetag: 27.02.2019
(51) Int. Cl.: H03K 17/955, G01D 5/24

(54) **ANORDNUNG FÜR EINE KAPAZITIVE SENSORVORRICHTUNG**
ASSEMBLY FOR A CAPACITIVE SENSOR DEVICE
SYSTÈME POUR UN DISPOSITIF DE DÉTECTION CAPACITIF

(30) Priorität: 21.03.2018 DE 102018106624
(43) Veröffentlichungstag der Anmeldung: 27.01.2021
(73) Patentinhaber: Huf Hülsbeck & Fürst GmbH & Co. KG, 42551 Velbert (DE)
(72) Erfinder: SIEG, Berthold, 46240 Bottrop (DE); STAHL, Daniel, 42549 Velbert (DE)
(74) Vertreter: Bals & Vogel Patentanwälte PartGmbB
(86) Internationale Anmeldenummer: PCT/EP2019/054826
(87) Internationale Veröffentlichungsnummer: WO 2019/179729

(56) Entgegenhaltungen:
- DE-A1- 102012 102 422
- DE-A1- 102012 105 266
- DE-A1- 102012 224 037
- DE-A1- 102013 112 909
- DE-A1- 102013 112 910
- US-A1- 2017 373 686
- "Capacitive Sensors: Design and Applications", 1 January 1997, WILEY-IEEE PRESS, ISBN: 978-0-7803-5351-0, article LARRY K. BAXTER: "Carrier", pages: 171 - 173, XP055587002
- ROBERT KEIM: "How to Low-Pass Filter a Square Wave", 7 March 2018 (2018-03-07), pages 1 - 9, XP055586988, Retrieved from the Internet <URL:https://www.allaboutcircuits.com/technical-articles/how-to-low-pass-filter-a-square-wave/> [retrieved on 20190508]

## Beschreibung

Die vorliegende Erfindung betrifft eine Anordnung für eine kapazitive Sensorvorrichtung eines Fahrzeuges. Ferner bezieht sich die Erfindung auf einen Außentürgriff sowie ein Verfahren zum Betreiben einer kapazitiven Sensorvorrichtung eines Fahrzeuges.

Es ist aus dem Stand der Technik bekannt, dass eine kapazitive Sensorvorrichtung mit einem Sensorelement an einem Fahrzeug genutzt werden kann, um Veränderungen in der Umgebung des Sensorelements, wie eine Bewegung oder eine Annäherung einer Person, zu detektieren. Zur Auswertung des Sensorelements kann dieses wiederholt aufgeladen und entladen werden, was entsprechend mit einer Ausgabe und einem Empfang elektrischer Signale innerhalb der Sensorvorrichtung einhergeht. Hierzu werden meist RechteckSignale genutzt, welche aufgrund des Umladens und/oder eines Umschaltens zwischen einem Entlade- und einem Auflade-Strompfad entstehen können.

Aus der US 2017 / 3 736 86 A1 ist eine kapazitive Sensorvorrichtung mit wenigstens einer Sensorelektrode zur Erfassung einer Veränderung in einer Umgebung des kapazitiven Sensors bekannt. Es ist dabei vorgesehen, dass ein sinusförmiges Signal an der Sensorelektrode direkt durch eine Spannungsquelle erzeugt wird.

Das Dokument "Capacitive Sensors: Design and application" von Larry K. Baxter vom 1. Januar 1997 diskutiert die Erzeugung einer Sinuswelle.

Im Dokument "How to Low-Pass Filter a Square Wave" von Robert Keim vom 7. März 2018 wird die Tiefpassfilterung einer Sinuswelle diskutiert.

Zur Auswertung des Sensorelements sind z. B. Umladeverfahren bekannt, wie sie in DE 10 2012 102 422 A1, DE 10 2012 105 266 A1, DE 10 2013 112 909 A1 oder DE 10 2013 112 910 A1 offenbart sind.

Ein häufiges Problem ist dabei, dass ein solches Signal zur Auswertung, und insbesondere ein Rechtecksignal, ein Spektrum mit ungünstigen Frequenzen aufweisen kann. So ist es denkbar, dass es bei der Umladung mittels des Signals an dem Sensorelement zu einer störenden Abstrahlung kommt. Entsprechend ist es oft eine technische Herausforderung und mit aufwendigen Maßnahmen verbunden, Störauswirkungen durch die Sensorvorrichtung auf die Umgebung zu reduzieren. Beispielsweise kann es zu Problemen aufgrund von Wechselwirkungen mit Funksignalen im Bereich von 510 kHz bis 1,71 MHz kommen. Solche Funksignale werden insbesondere durch externe Sender des Mittelwellenrundfunks (im AM-Band) oder dergleichen abgestrahlt. Die Maßnahmen zur Reduzierung und/oder Kompensation dieser Wechselwirkungen sind dabei häufig technisch komplex und kostenintensiv.

Es ist daher eine Aufgabe der vorliegenden Erfindung, die voranstehend beschriebenen Nachteile zumindest teilweise zu beheben. Insbesondere ist es eine Aufgabe der vorliegenden Erfindung, einen verbesserten Betrieb einer kapazitiven Sensorvorrichtung eines Fahrzeuges zu ermöglichen.

Die voranstehende Aufgabe wird gelöst durch eine Anordnung mit den Merkmalen des unabhängigen Vorrichtungsanspruchs, einen Außentürgriff mit den Merkmalen des weiteren, nebengeordneten Vorrichtungsanspruchs sowie durch ein Verfahren mit den Merkmalen des unabhängigen Verfahrensanspruchs. Weitere Merkmale und Details der Erfindung ergeben sich aus den jeweiligen Unteransprüchen, der Beschreibung und den Zeichnungen. Dabei gelten Merkmale und Details, die im Zusammenhang mit der erfindungsgemäßen Anordnung beschrieben sind, selbstverständlich auch im Zusammenhang mit dem erfindungsgemäßen Außentürgriff sowie dem erfindungsgemäßen Verfahren, und jeweils umgekehrt, so dass bezüglich der Offenbarung zu den einzelnen Erfindungsaspekten stets wechselseitig Bezug genommen wird bzw. werden kann.

Die Aufgabe wird insbesondere gelöst durch eine Anordnung nach Anspruch 1, zur Detektion einer Aktivierungshandlung beim Fahrzeug, z. B. im Front- und/oder Seiten- und/oder Heckbereich des Fahrzeuges. Die Aktivierungshandlung kann dabei z. B. durch eine Person in der Umgebung des Fahrzeuges durchgeführt werden. So kann die Person den Wunsch haben, eine Heckklappe des Fahrzeuges durch eine Geste am Heckbereich zu öffnen. Diese Geste ist z. B. ein Bewegen eines Körperteils unterhalb eines Stoßfängers, was durch die Sensorvorrichtung detektiert werden kann. Auch kann ggf. eine Geste in der Umgebung zu einem Türgriff des Fahrzeuges als Aktivierungshandlung vorgesehen sein, um z. B. eine Fahrzeugtür zu entriegeln und/oder zu öffnen.

Erfindungsgemäß weist die Anordnung die nachfolgenden Komponenten auf:
- wenigstens eine Sensorelektrode, zur Erfassung einer Veränderung in einer Umgebung des Fahrzeuges, insbesondere in einer Umgebung des Sensorelements, vorzugsweise in einem Bereich außerhalb des Fahrzeuges und/oder unterhalb eines Stoßfängers und/oder im Bereich eines Türgriffes, bevorzugt zur Erfassung der Geste und/oder der Aktivierungshandlung,
- eine Übertragungsanordnung zur Bereitstellung eines Ausgangssignals durch eine frequenzabhängige Veränderung eines elektrischen Eingangssignals der Übertragungsanordnung, wobei vorzugsweise das Eingangssignal an einem Eingang der Übertragungsanordnung bereitgestellt ist,
- einen Ausgang der Übertragungsanordnung, welcher elektrisch mit der Sensorelektrode verbunden ist, um die Sensorelektrode mit dem Ausgangssignal zu betreiben, vorzugsweise durch eine Übertragung des Ausgangssignals an die Sensorelektrode.

Hierbei ist erfindungsgemäß vorgesehen, dass die Übertragungsanordnung wenigstens eine Filterkomponente aufweist, um die frequenzabhängige Veränderung durchzuführen.

Dies hat den Vorteil, dass das Spektrum des Eingangssignals durch die Übertragungsanordnung angepasst werden kann, also z. B. (ungewünschte) störende Frequenzen des Eingangssignals herausgefiltert werden und/oder deren Abstrahlung bei dem Betreiben mit dem Ausgangssignal, insbesondere bei einem Ausgeben des Ausgangssignals an der Sensorelektrode, vermieden werden können. Dabei basiert die erfindungsgemäße Lösung insbesondere auf der Überlegung, dass die Nutzung eines Rechtecksignals als Ausgangssignal für die Sensorelektrode hinsichtlich möglicher Störfrequenzen besonders problematisch ist. Unter Umständen kann ohne weitere Maßnahmen nicht ausreichend gewährleistet werden, dass die Übertragung des Ausgangssignals und/oder die Ausgabe an der Sensorelektrode keine störenden Auswirkungen auf das Ausgangssignal und/oder einer elektromagnetischen Abstrahlung an der Sensorelektrode hat. Dies kann vermieden werden, indem die wenigstens eine Filterkomponente genutzt wird, um das Ausgangssignal in Abhängigkeit von dem Eingangssignal zu formen. Das Eingangssignal gibt bspw. als rechteckartiges Signal eine Auswertesequenz vor, also einen Takt und/oder eine zeitliche Abfolge von Umschaltvorgängen bei wenigstens einem Schalterelement. Die wenigstens eine Filterkomponente bewirkt dann eine Formung, also eine Anpassung hinsichtlich der Frequenzanteile beim Eingangssignal, z. B. eine Oberwellenunterdrückung. Insbesondere kann die Übertragungsanordnung dazu angepasst sein, z. B. durch eine entsprechende Anpassung der Filterkomponenten, dass ein sinusartiges Signal als Ausgangssignal ausgegeben wird. Dieses hat besonders vorteilhafte Eigenschaften hinsichtlich des Frequenzspektrums.

Vorteilhafterweise kann bei der erfindungsgemäßen Anordnung nur eine einzige (baulich ausgeführte) Sensorelektrode zur Ausbildung einer (veränderlichen) Sensorkapazität vorgesehen sein, wobei vorzugsweise die Gegenelektrode zur Ausbildung der Sensorkapazität durch eine Masse des Fahrzeuges gebildet ist, und damit nicht als separates (dediziertes) Bauteil angesehen wird. Bevorzugt werden parasitäre Kapazitäten der Sensorvorrichtung bei dieser Betrachtung vernachlässigt. Dies ermöglicht eine besonders einfache konstruktive Ausgestaltung.

Das Sensorelement, insbesondere die Sensorelektrode, kann ein Sensorelement aus einem elektrisch leitenden Material sein. Bspw. ist die Sensorelektrode als länglicher (längsgestreckter) elektrischer Leiter ausgeführt, bspw. als elektrisches Kabel, und optional lediglich über eine einzige direkte elektrische Verbindung mit der Fahrzeugelektronik verbunden.

Dabei kann unter einer elektrischen Verbindung sowohl eine direkte als auch eine indirekte Verbindung, d. h. auch über weitere elektrische Bauelemente, verstanden werden, allerdings vorzugsweise nur, sofern die Verbindung ausschließlich elektrisch erfolgt. Bspw. kann das elektrische Feld zwischen der Sensorelektrode und der Fahrzeugmasse hierbei nicht als direkte elektrische Verbindung aufgefasst werden, sodass die Sensorelektrode bevorzugt nur eine einzige direkte elektrische Verbindung zur Fahrzeugelektronik aufweist. Ggf. kann als die Fahrzeugelektronik auch zumindest die Sensorvorrichtung und/oder die Kontrollvorrichtung und/oder die Übertragungsanordnung verstanden werden.

Das Fahrzeug ist vorzugsweise als Kraftfahrzeug, bevorzugt Personenkraftfahrzeug, und/oder als Elektrofahrzeug und/oder als Hybridfahrzeug und/oder als autonomes Fahrzeug ausgebildet.

Es ist darüber hinaus denkbar, dass das wenigstens eine Sensorelement, vorzugsweise die wenigstens eine Sensorelektrode, in einem Front- und/oder Seiten- und/oder Heckbereich des Fahrzeuges angeordnet ist, um insbesondere die Veränderung in der Umgebung und/oder die Aktivierungshandlung entsprechend im genannten Umgebungsbereich, d. h. Front- und/oder Seiten- und/oder Heckbereich des Fahrzeuges, zu erfassen. Auf diese Weise kann die Aktivierungshandlung in diesem Umgebungsbereich zuverlässig durch die Sensorvorrichtung detektiert werden. Es können z. B. intuitiv anhand der Detektion Elemente und/oder Funktionen des Fahrzeuges in diesem Umgebungsbereich bewegt bzw. aktiviert werden. Solche Funktionen sind bspw. eine Beleuchtung des Fahrzeuges und/oder ein Entriegeln einer Schließvorrichtung des Fahrzeuges und/oder dergleichen. Die Elemente können z. B. als Heckklappe und/oder Seitentür und/oder Schiebetür und/oder Motorhaube ausgeführt sein, welche anhand der Detektion bewegt und/oder geöffnet und/oder geschlossen werden. Auch ist es optional möglich, dass das Sensorelement an einem und/oder innerhalb eines oder im Bereich eines Türschweller(s) angeordnet ist, um anhand der Detektion z. B. eine Seitentür oder Schiebetür des Fahrzeuges zu öffnen. Damit eine Bewegung und/oder ein Bewegungsmuster zuverlässig anhand der Detektion erfasst werden kann, können alternativ oder zusätzlich zu vorgenannten Merkmalen auch mindestens zwei Sensorelemente, vorzugsweise Sensorelektroden, vorgesehen sein. Diese sind bspw. gemeinsam in wenigstens einem der vorgenannten Umgebungsbereichen angeordnet, z. B. gemeinsam in einem Stoßfänger oder Türschweller oder Türgriff oder dergleichen.

Vorzugsweise kann die kapazitive Sensorvorrichtung das Sensorelement (bzw. die Sensorelektrode) und/oder die Übertragungsanordnung und/oder eine Kontrollvorrichtung aufweisen. Es kann eine Ansteuerung bei der kapazitiven Sensorvorrichtung darin gesehen werden, dass die Übertragungsanordnung das Ausgangssignal ausgibt, welches zur Aufladung an das Sensorelement übertragen wird. Die Auswertung kann darin gesehen werden, dass eine Halteanordnung der Kontrollvorrichtung Ladungen des Sensorelements über ein Empfangssignal empfängt, was z. B. zur Detektion der Aktivierungshandlung ausgewertet werden kann. Somit kann vorteilhafterweise zur Auswertung des Sensorelements (d. h. insbesondere der Sensorelektrode) eine Halteanordnung der Kontrollvorrichtung vorgesehen sein, welche ggf. durch eine Ansteuerungsvorrichtung ausgewertet wird, um eine zuverlässige Detektion zu ermöglichen.

Ferner kann es bei der erfindungsgemäßen Anordnung vorgesehen sein, dass die wenigstens eine Filterkomponente sowohl eine Ausgabe des Ausgangssignals (am Ausgang bzw. an einem Transmit-Pfad) als auch einen Empfang von Ladungen von der Sensorelektrode zu einer Halteanordnung (an einem Receive-Pfad) mittels eines Empfangssignals beeinflusst, vorzugsweise durch die frequenzabhängige Veränderung. Dies kann bspw. dadurch realisiert werden, dass die Halteanordnung mit der Übertragungsanordnung elektrisch verbunden ist.

Von weiterem Vorteil kann vorgesehen sein, dass die Übertragungsanordnung durch die wenigstens eine Filterkomponente als ein aktives elektronisches Filter, vorzugsweise als ein Sallen-Key-Filter, ausgebildet ist. Dies hat den Vorteil, dass das Ausgangssignal besonders zuverlässig, insbesondere als ein geführtes Signal, die durch die wenigstens eine Filterkomponente bewirkte Frequenzeigenschaften beibehält.

Vorzugsweise kann vorgesehen sein, dass die Übertragungsanordnung mittels der wenigstens einen Filterkomponente ein Allpass-Filter oder ein Tiefpass-Filter ausbildet, um bevorzugt das Eingangssignal derart zu filtern, dass bei dem Betrieb der Sensorelektrode eine Abstrahlung in einem störenden Frequenzbereich, vorzugsweise ab einer zweiten Harmonischen des Eingangssignals, zumindest reduziert wird. In anderen Worten kann es vorgesehen sein, dass die Übertragungsanordnung dazu ausgeführt ist, eine Unterdrückung von Oberschwingungen des Eingangssignals durchzuführen, um eine Oberwellenunterdrückung bei der Ausgabe des Ausgangssignals an der Sensorelektrode durchzuführen. Dies hat den Vorteil, dass die Übertragungsanordnung einen Oberwellenfilter ausbilden kann, um Störungen durch das Ausgangssignal zumindest zu reduzieren. Der störende Frequenzbereich ist dabei insbesondere ein vordefinierter Frequenzbereich, und ist bspw. abhängig von regional genutzten Sendern und Funkfrequenzen oder dergleichen. Die Harmonische gibt vorzugsweise eine Schwingung mit einer solchen Frequenz an, welche einem ganzzahligen Vielfachen einer Grundfrequenz des Eingangssignals entspricht. Die Grundfrequenz ist bspw. eine Arbeitsfrequenz von im Wesentlichen 333 kHz. Eine Harmonische oberhalb der Grundfrequenz wird dabei auch Oberschwingung oder Oberwelle genannt.

Von besonderem Vorteil kann bei der erfindungsgemäßen Anordnung vorgesehen sein, dass die wenigstens eine Filterkomponente zur Ausbildung eines elektronischen Filters ausgeführt ist, vorzugsweise eines Tief- und/oder Bandpass-Filters, um bevorzugt die frequenzabhängige Veränderung des Eingangssignals durchzuführen, wobei besonders bevorzugt die wenigstens eine Filterkomponente mit einer Quellenvorrichtung als weitere Filterkomponente verschaltet ist, sodass ein aktives Filter, besonders bevorzugt ein Sallen-Key-Filter, ausgebildet ist. Die Quellenvorrichtung ist bspw. eine gesteuerte Quellenvorrichtung, insbesondere Spannungsquellenvorrichtung. Sie kann als ein reales elektrisches Bauelement oder als eine elektrische Schaltung verstanden werden, welche(s) annähernd die Funktion einer idealen gesteuerten Quelle (engl. auch: "dependent source"), insbesondere Spannungsquelle, aufweist. Somit kann die Quellenvorrichtung als reale gesteuerte Quelle, insbesondere reale Spannungsquelle (CVS, engl. "controlled voltage source"), aufgefasst werden. Ein Beispiel für eine solche Quellenvorrichtung ist ein Operationsverstärker (OP), insbesondere ein gesteuerter, vorzugsweise spannungsgesteuerter, Operationsverstärker. Besonders vorteilhaft ist, wenn die Quellenvorrichtung als eine (reale) niederohmig gesteuerte (Spannungs-) Quelle ausgeführt ist. Dies hat den Vorteil, dass das Ausgangssignal als geführtes Ausgangssignal besonders zuverlässig die Signalformung beibehält.

Nach einer weiteren Möglichkeit kann vorgesehen sein, dass die wenigstens eine Filterkomponente eine erste Filterkomponente, insbesondere zur Ausbildung eines RC-Tiefpass-Filters, und eine zweite Filterkomponente, insbesondere zur Ausbildung eines Sallen-Key-Filters, umfasst, wobei die Filterkomponenten miteinander verschaltet sind, um gemeinsam die frequenzabhängige Veränderung des Eingangssignals durchzuführen. Vorzugsweise die zweite Filterkomponente kann dabei auch einen Operationsverstärker aufweisen. Dies kann besonders zuverlässig die störenden Frequenzen filtern, da ein sinusartiges Signal bereitgestellt werden kann.

Vorteilhafterweise kann im Rahmen der Erfindung vorgesehen sein, dass das Ausgangssignal in Abhängigkeit von der frequenzabhängigen Veränderung des Eingangssignals dadurch bereitstellbar ist, dass die wenigstens eine Filterkomponente zwischen dem Ausgang und einem Eingang der Übertragungsanordnung verschaltet ist. Insbesondere erfolgt die Bereitstellung des Ausgangssignals derart, dass das durch die Filterkomponente veränderte Eingangssignal an einem Steuereingang einer Quellenvorrichtung anliegt, um die Quellenvorrichtung hinsichtlich der Ausgabe des Ausgangssignals zu steuern, und ein Ausgang der Quellenvorrichtung mit dem Ausgang der Übertragungsanordnung verbunden ist oder diesem entspricht. Ferner kann auch eine Rückkopplung bei der Quellenvorrichtung vorgesehen sein, um bspw. als Quellenvorrichtung einen Operationsverstärker zu nutzen. Der Operationsverstärker kann ggf. eine Verstärkung mit einem Verstärkungsfaktor von 1 zwischen einem (z. B. nicht invertierenden) Ein- und Ausgang des Operationsverstärkers bereitstellen.

Erfindungsgemäß ist vorgesehen, dass eine Eingangssignalquelle mit einem Eingang der Übertragungsanordnung verbunden ist, um das Eingangssignal als ein auf ein Rechtecksignal basierendes Signal am Eingang bereitzustellen, welches durch Signalformung aktiv verändert ist, durch ein Verschleifen der Flanken des Rechtecksignals und durch eine zeitlich veränderliche Amplitude, insbesondere bei Pulsen des Rechtecksignals innerhalb der Pulsdauer, um die frequenzabhängige Veränderung, vorzugsweise eine Oberwellenunterdrückung, der Übertragungsanordnung zu unterstützen. Es ist hierbei vorteilhaft, wenn die Eingangssignalquelle, vorzugsweise eine Ansteuerungsvorrichtung und/oder eine Ansteuerungsanordnung, bereits eine erste Signalformung bereitstellt. Diese kann die weitere Formung durch die wenigstens eine Filterkomponente unterstützten. Hierzu wird ein Rechtecksignal (d. h. ein zumindest rechteckartiges Signal, ggf. mit Unterbrechungen) bspw. durch die Eingangssignalquelle vorgefiltert, sodass bereits eine erste Abschwächung von Oberwellen erfolgt, welche durch die Übertragungsanordnung noch weiter verstärkt wird.

Auch ist es optional denkbar, dass eine Ansteuerungsvorrichtung als Teil einer Eingangssignalquelle vorgesehen ist, um das Eingangssignal, vorzugsweise über einen Digital-Analog-Wandler, zu erzeugen. Der Digital-Analog-Wandler ist bspw. Teil der Ansteuerungsvorrichtung und/oder separat dazu ausgebildet. Bereits bei dieser Erzeugung kann ein von einem Rechtecksignal abweichendes Signal bereitgestellt werden, welches z. B. das Verschleifen der Flanken aufweist. Die Erzeugung des Eingangssignals wird bspw. durch ein Anpassungsmittel vorgegeben.

Des Weiteren ist es denkbar, dass zur Signalformung des Eingangssignals eine Ansteuerungsanordnung als Teil einer Eingangssignalquelle vorgesehen ist, welche vorzugsweise zwischen einem Eingang der Übertragungsanordnung und einer Ansteuerungsvorrichtung verschaltet ist, um bevorzugt ein durch die Ansteuerungsvorrichtung erzeugtes Eingangssignal durch die Signalformung zu verändern und an dem Eingang der Übertragungsanordnung anzulegen. Somit kann die Ansteuerungsanordnung, bspw. als Widerstandsnetzwerk oder dergleichen, bereits zur Formung und/oder Vorfilterung des Eingangssignals dienen.

Vorteilhafterweise kann bei der Erfindung vorgesehen sein, dass eine Ansteuerungsvorrichtung als Teil einer Eingangssignalquelle dazu ausgeführt ist, eine Ansteuerungsanordnung derart anzusteuern, dass das Eingangssignal einem reckeckartigen Signal entspricht, welches zwischen ersten und zweiten Werten hin- und her wechselt, wobei vorzugsweise die ersten und zweiten Werte an- und wieder absteigend sich zeitlich verändern. In anderen Worten können zeitlich nacheinander ausgegebene Pulse des Signals unterschiedliche (maximale) Amplituden aufweisen. Dies kann eine Treppenform bei dem Eingangssignal bewirken, welche besonders effektiv die Signalformung und/oder frequenzabhängige Veränderung durch die wenigstens eine Filterkomponente unterstützen kann.

Ein weiterer Vorteil kann im Rahmen der Erfindung erzielt werden, wenn ein Schalterelement zwischen dem Ausgang der Übertragungsanordnung und der Sensorelektrode verschaltet ist, um (vorzugsweise durch eine Ansteuerungsvorrichtung) gesteuert, bevorzugt wiederholt und/oder getaktet, einen Receive-Pfad und einen Transmit-Pfad abwechselnd mit der Sensorelektrode zu verbinden, wobei bevorzugt der Ausgang (insbesondere direkt) mit dem Transmit-Pfad verbunden ist, und/oder eine Halteanordnung zur Auswertung bei der Sensorvorrichtung (insbesondere direkt) mit dem Receive-Pfad verbunden ist. Dies ermöglicht z. B. die Durchführung eines Umladeverfahrens zur Auswertung einer veränderlichen Kapazität (Sensorkapazität), welche durch die Sensorelektrode bereitgestellt wird. Das Schalterelement ist bspw. als ein elektronischer Schalter ausgebildet, welcher elektrisch durch die Ansteuerungsvorrichtung schaltbar ist.

Ferner ist es bei der erfindungsgemäßen Anordnung denkbar, dass der Ausgang der Übertragungsanordnung über wenigstens ein Schalterelement mit der Sensorelektrode verbunden ist, wobei vorzugsweise das Schalterelement mit einer Ansteuerungsvorrichtung verbunden ist, um das Ausgangssignal wiederholt, vorzugsweise getaktet, an der Sensorelektrode auszugeben. Hierzu kann die Ansteuerungsvorrichtung z. B. mit einem Steuereingang des Schalterelements zum Umschalten verbunden sein. Alternativ oder zusätzlich ist es denkbar, dass eine Halteanordnung über das wenigstens eine Schalterelement mit der Sensorelektrode verbunden ist, wobei das Schalterelement mit der Ansteuerungsvorrichtung verbunden ist, um die Halteanordnung wiederholt, vorzugsweise getaktet, mit der Sensorelektrode zu verbinden, vorzugsweise abwechselnd zu der Ausgabe des Ausgangssignals an der Sensorelektrode. Dies ermöglicht insbesondere die Durchführung eines Umladeverfahrens.

Optional kann es vorgesehen sein, dass eine Halteanordnung zur Auswertung bei der Sensorvorrichtung in einem Receive-Pfad integriert ist, um vorzugsweise nach einer Aufladung der Sensorelektrode durch das Ausgangssignal ein Empfangssignal in Abhängigkeit von der in der Sensorelektrode gespeicherten Ladung und/oder in Abhängigkeit von einer veränderlichen Sensorkapazität der Sensorvorrichtung zu empfangen, wobei die Sensorelektrode zur Bereitstellung der Sensorkapazität ausgeführt ist.

Damit kann in einfacher Weise eine Aktivierungshandlung in der Umgebung detektiert wird, wenn sich die Sensorkapazität signifikant verändert.

Ferner kann es im Rahmen der Erfindung vorgesehen sein, dass die Sensorelektrode dazu ausgeführt ist, in elektrischer Wirkverbindung mit der Umgebung des Fahrzeuges anordenbar zu sein, vorzugsweise in einem Stoßfänger oder in einem Türgriff des Fahrzeuges, sodass bei dem Betrieb der Sensorelektrode ein elektrisches Feld in der Umgebung entsteht, um eine veränderliche Sensorkapazität in Abhängigkeit von der Umgebung bereitzustellen. Die Ausbildung des Sensorelements als Sensorelektrode hat dabei insbesondere auch Vorteile für eine solche Anordnung im Türgriff oder im Stoßfänger, da die Sensorelektrode flexibel oder biegbar oder elastisch oder besonders platzsparend ausgeführt sein kann.

Außerdem kann es im Rahmen der Erfindung von Vorteil sein, dass eine Halteanordnung zur Auswertung einer veränderlichen Sensorkapazität vorgesehen ist, um vorzugsweise die Veränderung in der Umgebung des Fahrzeuges anhand dieser Auswertung zu detektieren, wobei bevorzugt die Halteanordnung als Integrator ausgebildet ist, um insbesondere eine Ladungsakkumulation anhand einer in der Sensorelektrode gespeicherten Ladung durchzuführen. In anderen Worten kann die Halteanordnung mittels einer Haltekapazität eine Ladungsmenge (ggf. auch über einen Stromspiegel) zwischenspeichern, welche von der Sensorelektrode durch ein Empfangssignal empfangen wird. Ferner kann die Halteanordnung auch eine Schaltung mit wenigstens einem Operationsverstärker aufweisen, welche mit frequenzabhängiger Gegenkopplung, vorzugsweise durch wenigstens einen Kondensator, ausgeführt ist, um den Integrator (auch: Integrierer) auszubilden. Dies ermöglicht eine besonders einfache und kostengünstige Auswertung.

Es ist ferner denkbar, dass die Übertragungsanordnung mit einer Halteanordnung verbunden ist, um ein Empfangssignal von der Sensorelektrode in Abhängigkeit von der frequenzabhängigen Veränderung bei der Halteanordnung zu empfangen, vorzugsweise um die frequenzabhängige Veränderung auch für das Empfangssignal für die Auswertung bei der Sensorvorrichtung bereitzustellen, d. h. insbesondere um ein Empfangssignal von der Sensorelektrode in Abhängigkeit von der frequenzabhängigen Veränderung zu empfangen. Bspw. durch die Nutzung einer Rückkopplung zur Auswertung des Empfangssignals bei der Halteanordnung kann dabei ein durch die wenigstens eine Filterkomponente verändertes Signal sich auf das Empfangssignal auswirken. Dieses veränderte Signal wird z. B. über eine elektrische Leitung von der Übertragungsanordnung an die Halteanordnung, z. B. an einen Integratoreingang, geführt. Damit kann die vorteilhafte Frequenzanpassung durch die Übertragungsanordnung sowohl für das Ausgangssignal, also für die Ansteuerung, als auch für das Empfangssignal, also für die Auswertung, bereitgestellt werden.

Ein weiterer Vorteil kann im Rahmen der Erfindung erzielt werden, wenn ein Operationsverstärkereingang der Übertragungsanordnung (bevorzugt eines Operationsverstärkers zur Bereitstellung eines aktiven Filters) mit einem (ersten) Integratoreingang der Halteanordnung verbunden ist, um vorzugsweise ein Empfangssignal von der Sensorelektrode in Abhängigkeit von der frequenzabhängigen Veränderung zu empfangen, sodass bevorzugt die frequenzabhängige Veränderung sowohl für das Empfangssignal in einem Receive-Pfad als auch für das Ausgangssignal in einem Transmit-Pfad bereitgestellt wird. Diese Verbindung zwischen Übertragungsanordnung und Halteanordnung dient dabei vorzugsweise auch dazu, um bei einer Auswertung das Empfangssignal zu formen, wobei vorzugsweise der Receive-Pfad mit einem zweiten Integratoreingang der Halteanordnung verbunden ist. Auf diese Weise kann durch die frequenzabhängige Veränderung die spektrale Beeinflussung, insbesondere eine Oberwellenunterdrückung, sowohl beim Ausgangssignal als auch beim Empfangssignal erfolgen. Damit können Störungen noch weitergehender vermieden werden.

Ferner ist es denkbar, dass die Übertragungsanordnung ein Filter mit Tiefpass-Eigenschaft ausbildet, welches eine Grenzfrequenz in einem Bereich von 100 kHz bis 800 kHz, vorzugsweise 200 kHz bis 600 kHz, bevorzugt 400 kHz bis 550 kHz, besonders bevorzugt 470 kHz aufweist. Dies kann insbesondere durch eine entsprechende Anpassung der Bauelemente der Übertragungsanordnung bereitgestellt werden. Alternativ oder zusätzlich kann die Übertragungsanordnung dazu ausgeführt sein, die Filtereigenschaften eines aktiven Tiefpassfilters aufzuweisen, insbesondere dritter Ordnung und/oder mit einer Abschwächung in Höhe von -20 dB bei 1 MHz und/oder einer Grenzfrequenz von 470 kHz. In anderen Worten kann eine Oberwellenunterdrückung von mindestens -20 dB bereitgestellt werden. Das Filter eignet sich dabei besonders für eine Arbeitsfrequenz der Sensorvorrichtung 20 in Höhe von (im Wesentlichen) 333 kHz, welche durch die Frequenz der Umschaltungen zwischen den Umladephasen und/oder Übertragungsphasen bestimmt werden kann. Insbesondere können damit Oberschwingungen ab der 2. Harmonischen oder 3. Harmonischen effektiv unterdrückt werden.

Ebenfalls Gegenstand der Erfindung ist ein Außentürgriff für ein Fahrzeug, aufweisend eine erfindungsgemäße Anordnung, wobei der Außentürgriff z. B. zur Anordnung an einer Seitentür oder Heckklappe des Fahrzeuges ausgeführt ist.

Ebenfalls unter Schutz gestellt ist eine Sensorvorrichtung mit der erfindungsgemäßen Anordnung.

Außerdem unter Schutz gestellt ist ein Verfahren zum Betreiben einer kapazitiven Sensorvorrichtung eines Fahrzeuges, welche die erfindungsgemäße Anordnung aufweist, insbesondere zur Ansteuerung und/oder Auswertung bei der kapazitiven Sensorvorrichtung zur Detektion einer Aktivierungshandlung beim Fahrzeug, vorzugsweise im Seiten- und/oder Front- und/oder Heckbereich des Fahrzeuges. Hierbei ist vorgesehen, dass die Sensorvorrichtung wenigstens eine Sensorelektrode zur Bereitstellung einer Sensorkapazität aufweist.

Bei dem erfindungsgemäßen Verfahren werden die nachfolgenden Schritte durchgeführt :
a) Umschalten wenigstens eines Schalterelements, um einen Transmit-Pfad mit der Sensorelektrode zu verbinden,
b) Erzeugen eines elektrischen Eingangssignals, insbesondere an einem Eingang einer Übertragungsanordnung, vorzugsweise durch eine Ansteuerungsvorrichtung, wie einem Mikrocontroller,
c) Durchführen einer frequenzabhängigen Veränderung des elektrischen Eingangssignals zur Bereitstellung eines Ausgangssignals, vorzugsweise an einem Ausgang der Übertragungsanordnung, bevorzugt durch die Übertragungsanordnung, besonders bevorzugt durch wenigstens eine Filterkomponente,
d) Ausgabe des Ausgangssignals über den Transmit-Pfad an der Sensorelektrode,
e) Umschalten des wenigstens einen Schalterelements, um einen Receive-Pfad mit der Sensorelektrode zu verbinden, und vorzugsweise die Verbindung mit dem Transmit-Pfad aufzuheben,
f) Übertragen eines Empfangssignals von der Sensorelektrode zu einer Halteanordnung im Receive-Pfad, um die Sensorkapazität auszuwerten.

Damit bringt das erfindungsgemäße Verfahren die gleichen Vorteile mit sich, wie sie ausführlich mit Bezug auf eine erfindungsgemäße Anordnung beschrieben worden sind.

Gemäß einer vorteilhaften Weiterbildung der Erfindung kann vorgesehen sein, dass durch die frequenzabhängige Veränderung eine Oberwellenunterdrückung sowohl beim Ausgangssignal als auch beim Empfangssignal erfolgt. Dies kann bevorzugt durch eine Verbindung zwischen der Halteanordnung und der Übertragungsanordnung bewirkt werden. Hierdurch lassen sich durchgehend beim Betrieb des Sensorelements Störungen vermeiden. Bevorzugt kann im Rahmen der Erfindung vorgesehen sein, dass das Erzeugen des elektrischen Eingangssignals als ein periodisches Signal wiederholt zur Bereitstellung einer Unterbrechungsphase unterbrochen wird, um die Ausgabe des Ausgangssignals und insbesondere auch das Übertragen des Empfangssignals zu pausieren, vorzugsweise derart, dass das Ausgangssignal als Burst-Signal ausgegeben wird. In anderen Worten kann nach wiederholten Übertragungen des Ausgangssignals an die Sensorelektrode und Übertragungen des Empfangssignals von der Sensorelektrode eine Pausierung erfolgen. Diese Pausierung, also die Unterbrechungsphase, kann dabei regelmäßig durchgeführt werden, um den Energieverbrauch herabzusenken. Um dies zu ermöglichen, wird bspw. durch die Ansteuerungsvorrichtung als Eingangssignal ein "Null-Signal" ausgegeben, also z. B. eine Spannung in Höhe von 0 V oder dergleichen.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind.

Es zeigen:
Fig. 1 eine perspektivische Darstellung eines Hecks eines Fahrzeuges mit einem Benutzer,
Fig. 2 ein schematisches Prinzip-Schaltbild einer Sensorvorrichtung,
Fig. 3 eine schematische Darstellung einer erfindungsgemäßen Anordnung,
Fig. 4 eine schematische Darstellung einer Sensorvorrichtung,
Fig. 5 schematische Darstellungen von Signalverläufen,
Fig. 6 eine weitere schematische Darstellung einer erfindungsgemäßen Anordnung.

In den nachfolgenden Figuren werden für die gleichen technischen Merkmale auch von unterschiedlichen Ausführungsbeispielen die identischen Bezugszeichen verwendet.

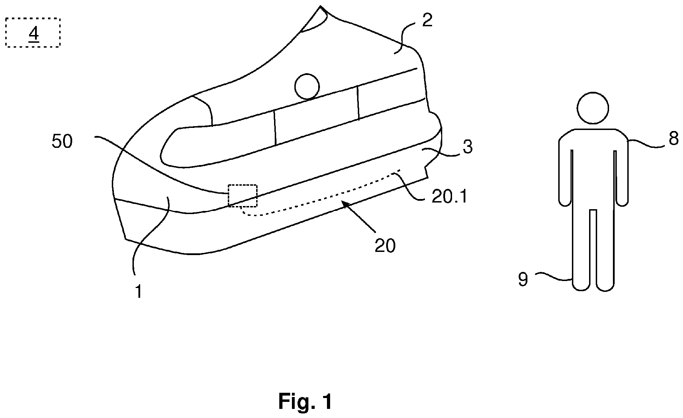

Figur 1 zeigt schematisch eine perspektivische Ansicht eines Fahrzeuges 1. Es ist eine Heckklappe 2 oberhalb eines Stoßfängers 3 des Fahrzeuges 1 dargestellt, wobei die Heckklappe 2 bspw. gemäß einer (ersten) Fahrzeugfunktion geöffnet und/oder gemäß einer (zweiten) Fahrzeugfunktion wieder geschlossen werden kann. Es kann in den Stoßfänger 3 wenigstens ein Sensorelement 20.1, insbesondere eine Sensorelektrode 20.1, einer kapazitiven Sensorvorrichtung 20 integriert sein. Alternativ oder zusätzlich kann das wenigstens eine Sensorelement 20.1 auch in einen (Außen-) Türgriff 4 des Fahrzeuges 1 oder einer sonstigen Fahrzeugkomponente integriert sein. Die kapazitive Sensorvorrichtung 20 weist entsprechend einen kapazitiven Sensor auf, welcher zumindest teilweise durch das Sensorelement 20.1 gebildet wird. Das Sensorelement 20.1 ist bevorzugt kabelförmig und/oder mit einer länglichen Erstreckung ausgebildet, um einen möglichst gestreckten Erfassungsbereich zur Erfassung einer Aktivierungshandlung bereitzustellen. Auch ist es denkbar, dass das Sensorelement 20.1 eine von einer länglichen Erstreckung abweichende Erstreckung aufweist, z. B. im Wesentlichen eine Kreisform oder Rechteckform oder Punktform oder dergleichen. Die Aktivierungshandlung ist bspw. die Bewegung eines Aktivierungsmittels 9, wie eines Körperteils 9, insbesondere Fußes 9, eines Benutzers 8 in einer Umgebung außerhalb des Fahrzeuges 1 bzw. des Sensorelements 20.1. Zur Durchführung der Aktivierungshandlung ist eine Möglichkeit, dass der Benutzer 8 das Aktivierungsmittel 9 unter den Stoßfänger 3 bewegt. Diese Bewegung wird dann als Veränderung einer Sensorkapazität CS der kapazitiven Sensorvorrichtung 20 erfasst, und kann vorzugsweise durch eine Kontrollvorrichtung 50 der Sensorvorrichtung 20 ausgewertet und detektiert werden. Die Kontrollvorrichtung 50 wird hierzu mit dem Sensorelement 20.1 elektrisch verbunden und/oder verschaltet. Entsprechend kann es sinnvoll sein, wenn die Kontrollvorrichtung 50 als Steuergerät des Fahrzeuges 1 ausgebildet ist, vorzugsweise als Teil der - oder elektrisch verbunden mit der - Fahrzeugelektronik. Dabei ist es denkbar, dass zur Reduzierung des Schaltungsaufwandes lediglich eine einzige elektrische Verbindung, z. B. eine einzige elektrische Leitung wie ein Kabel, von der Kontrollvorrichtung 50 zum Sensorelement 20.1 führt, dieses also nur über eine einzige elektrisch leitende Verbindung verbunden ist. Damit entspricht das Sensorelement 20 einer Sensorelektrode 20.1 zur Bereitstellung der Sensorkapazität CS. Weiter ist es möglich, dass eine Detektion der Aktivierungshandlung durch die Kontrollvorrichtung 50 erfolgt, welche sodann die Fahrzeugfunktion oder wenigstens eine der Fahrzeugfunktionen aktiviert.

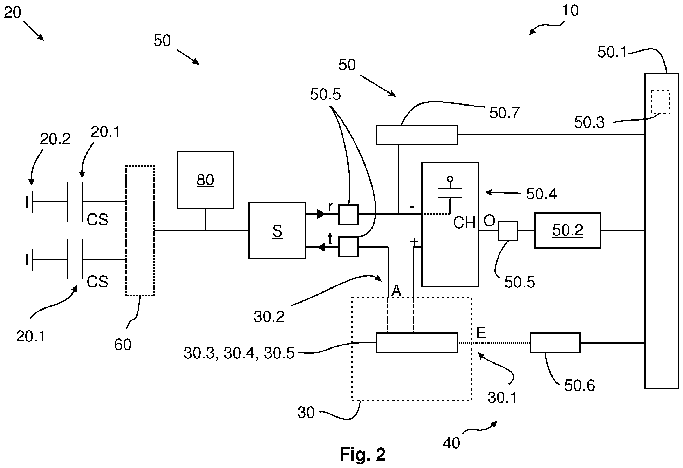

In Figur 2 ist das Erfassungsprinzip zur Detektion der Aktivierungshandlung und zur Auswertung der Sensorkapazität CS näher anhand eines Prinzip-Schaltbilds der kapazitiven Sensorvorrichtung 20 und einer erfindungsgemäßen Anordnung 10, insbesondere Schaltungsanordnung 10, dargestellt. Es können nur ein oder ggf. auch mehrere Sensorelemente 20.1 vorgesehen sein. Beispielhaft gezeigt sind in Figur 2 zwei Sensorelemente 20.1 in der Form von Sensorelektroden 20.1, welche jeweils eine Sensorkapazität CS bereitstellen können. In anderen Worten kann ein Sensorelement 20.1 bzw. eine Sensorelektrode 20.1 jeweils einen kapazitiven Sensor bereitstellen, welcher jeweils als Kondensator aufgefasst werden kann. Bei mehreren Sensorelementen 20.1 kann wenigstens eine Schaltvorrichtung 60 mit wenigstens einem selektiven Schalter vorgesehen sein, welcher abwechselnd die Sensorelemente 20.1 auswählt, also eine elektrische Verbindung dazu herstellt. Die wenigstens eine Schaltvorrichtung 60 verbindet dabei die Sensorelemente 20.1 abwechselnd z. B. mit einer Vorfilteranordnung 80 und/oder wenigstens einem Schalterelement S. Die Nutzung von wenigstens zwei Sensorelementen 20.1 hat dabei den Vorteil, dass z. B. Bewegungen und/oder Bewegungsmuster erfasst werden können.

Das jeweilige Sensorelement 20.1 kann ein elektrisch leitendes Material aufweisen, um jeweils eine (einzige) Sensorelektrode 20.1 auszubilden. Zur Bereitstellung der Sensorkapazität CS genügt es dabei, wenn lediglich die jeweilige Sensorelektrode 20.1 ohne Gegenelektrode vorgesehen ist. In diesem Fall sind die in Figur 2 dargestellten Gegenelektroden (gegenüber den jeweiligen Sensorelementen 20.1) lediglich repräsentativ zur Veranschaulichung des Prinzips und nicht als tatsächliches Bauteil anzusehen. Alternativ kann auch wenigstens eine oder für jedes Sensorelement 20.1 eine zugeordnete Gegenelektrode baulich vorgesehen sein.

Jedes Sensorelement 20.1 kann die Sensorkapazität CS gegenüber einem Massepotential 20.2, insbesondere der Fahrzeugmasse, und der Umgebung des Fahrzeuges 1 ausbilden. Die Sensorkapazität CS ist somit durch die Umgebung des Fahrzeuges 1 veränderbar, insbesondere also dann, wenn ein Aktivierungsmittel 9 sich in den Umgebungsbereich des Sensorelements 20.1 bewegt. Auf diese Weise kann anhand der Sensorkapazität CS sehr zuverlässig eine Aktivierungshandlung erfasst werden.

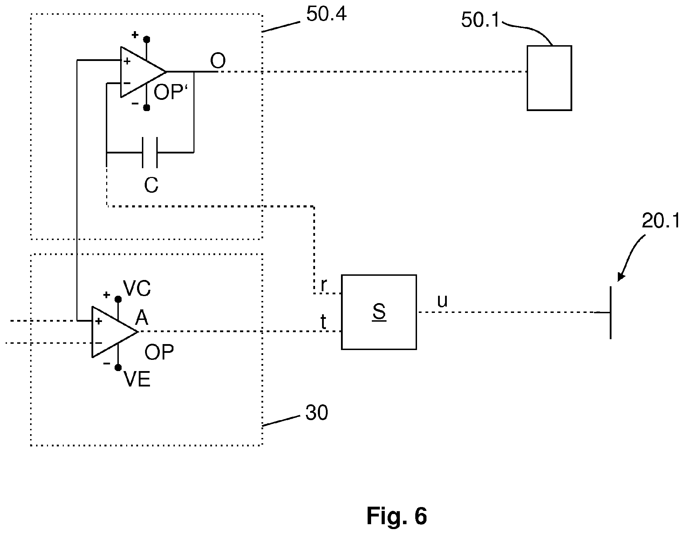

Für die Auswertung der Sensorkapazität CS kommen verschiedene Verfahren in Betracht. Die Verfahren basieren dabei insbesondere darauf, dass eine Umladung der in dem Sensorelement 20.1 befindlichen bzw. der mittels der Sensorkapazität CS gespeicherten Ladung auf eine Halteanordnung 50.4 mit einer Haltekapazität CH bewirkt wird. Es wird dabei der Umstand genutzt, dass die gespeicherte Ladung abhängig von der veränderlichen Sensorkapazität CS und damit von der Umgebung des Fahrzeuges 1 (z. B. der Aktivierungshandlung) ist. Die Halteanordnung 50.4 kann hierbei einen Haltekondensator aufweisen, welcher zur Ladungsakkumulation und/oder Zwischenspeicherung und Auswertung der Ladung durch die Kontrollvorrichtung 50 dient. Vorteilhafterweise weist die Halteanordnung 50.4 einen Operationsverstärker OP' auf, welcher ggf. mit wenigstens einem weiteren Bauelement und/oder einer (ggf. als phasen- und/oder frequenzabhängig ausgebildeten) Rückkopplung (z. B. über einen Kondensator) einen Integrator ausbildet (siehe hierzu auch Figur 6). Der Integrator dient dabei zur Speicherung einer Ladungsmenge, welche spezifisch ist für die von dem Sensorelement 20.1 bei der Umladung über ein Empfangssignal empfangen Ladungsmenge. Der Operationsverstärker OP' kann über einen Ausgang O mit einer Ansteuerungsvorrichtung 50.1 z. B. in der Form eines Mikrocontrollers ggf. über einen Analog-Digital-Wandler 50.2 verbunden sein, um die gespeicherte Ladungsmenge auszuwerten.

Zur Umladung kann vorteilhafterweise eine wiederholt durchgeführte Empfangsphase (auch Umladephase genannt) genutzt werden. Die Empfangsphase kann eine bestimmte Schaltphase sein, also ein Schaltzustand wenigstens eines Schalterelements S. Hierzu wird bspw. das wenigstens eine Schalterelement S, insbesondere wenigstens ein Umschalter S, wiederholt umgeschaltet, vorzugsweise mit einer Frequenz von 333 kHz. Die Empfangsphase liegt in diesem Fall dann vor, wenn das Schalterelement S einen Receive-Pfad r mit dem Sensorelement 20.1 elektrisch verbindet. Nach einem weiteren Umschalten des Schalterelements S in einen anderen Schaltzustand liegt hingegen eine Übertragungsphase (ggf. auch Aufladephase genannt) vor, in welcher das Schalterelement S einen Transmit-Pfad t mit dem Sensorelement 20.1 elektrisch verbindet. Beide Pfade r, t können dabei als Leitungen (z. B. auf einer Leiterplatte) ausgeführt sein, welche somit eine elektrisch leitende Verbindung bereitstellen.

Die Übertragungsphase kann dazu genutzt werden, um dem Sensorelement 20.1 Ladung zuzuführen, also eine Aufladung des kapazitiven Sensors zu bewirken. Hierzu wird bspw. das Sensorelement 20.1 in der Übertragungsphase elektrisch über das Schalterelement S und über den Transmit-Pfad t mit einer Übertragungsanordnung 30 verbunden. Dies bewirkt die Übertragung eines Ausgangssignals A über den Transmit-Pfad t, insbesondere von der Übertragungsanordnung 30 an das Sensorelement 20.1. Die Empfangsphase kann dagegen dafür genutzt werden, um aus dem Sensorelement 20.1 darin befindliche (aufgrund der Sensorkapazität CS gespeicherte) Ladung zu empfangen, also die Umladung zu bewirken. Hierzu wird bspw. das Sensorelement 20.1 in der Empfangsphase elektrisch über das Schalterelement S und über den Receive-Pfad r mit einer Halteanordnung 50.4 verbunden. Dies bewirkt die Übertragung eines Empfangssignals über den Receive-Pfad r, insbesondere von dem Sensorelement 20.1 an die Halteanordnung 50.4. Darüber hinaus kann auch noch die Schaltvorrichtung 60 wiederholt umgeschaltet werden, um abwechselnd die unterschiedlichen Sensorelemente 20.1 mit dem Receive- und Transmit-Pfad r,t zu verbinden.

Im Folgenden wird die Empfangsphase näher betrachtet, welche zur Auswertung bei der Sensorvorrichtung 20 dienen kann. In der Empfangsphase kann die mittels der Sensorkapazität CS gespeicherte Ladung "umgeladen" werden, also in Abhängigkeit (z. B. proportional) zur Sensorkapazität CS bzw. zur dadurch gespeicherten Ladung die Halteanordnung 50.4 mit der Haltekapazität CH (bspw. eines Haltekondensators) aufgeladen werden. Dabei kann die Umladung ggf. über ein Tiefpass-Filter 50.5 und/oder bspw. auch über einen nicht explizit gezeigten Stromspiegel erfolgen. Der daraufhin für die Detektion der Aktivierungshandlung relevante Ladezustand der Halteanordnung 50.4 bzw. des Haltekondensators kann insbesondere anhand einer Spannung über oder seriell zum Haltekondensator, optional über den Analog-Digital-Wandler 50.2, ermittelt werden. Hierzu kann der Analog-Digital-Wandler 50.2 einerseits z. B. über ein Tiefpass-Filter 50.5 mit der Halteanordnung 50.4 und andererseits mit der Ansteuerungsvorrichtung 50.1 verbunden sein. Darüber hinaus kann optional auch wenigstens ein weiteres Kontrollelement 50.7 (auch: Kompensator) mit dem Receive-Pfad r verbunden sein, um z. B. eine Kompensation von einem Ladungsüberschuss bei der Umladung vorzunehmen. Hierzu kann das Kontrollelement 50.7 bspw. eine Regelschaltung umfassen. Somit kann das Kontrollelement 50.7 (ggf. zusammen mit weiteren Elementen wie der Ansteuerungsvorrichtung 50.1) dazu ausgeführt sein, einen Ladungsüberschuss (wenn also die umgeladene Ladungsmenge nicht mehr durch die Haltekapazität CH gespeichert werden kann) zu detektieren und/oder eine Kompensation durchzuführen.

Die Ansteuerungsvorrichtung 50.1 der Kontrollvorrichtung 50 kann bspw. als ein Mikrocontroller oder dergleichen ausgeführt sein, und ggf. auch die (insbesondere wiederholte und/oder getaktete) Umschaltung des Schalterelements S durchführen. Insbesondere kann die Ansteuerungsvorrichtung 50.1 dies in Abhängigkeit von wenigstens einem Anpassungsmittel 50.3, vorzugsweise eines Computerprogramms, durchführen, um so eine Phasendauer der Empfangsphase und/oder der Übertragungsphase zu bestimmen und/oder zu variieren. Darüber hinaus kann durch die Ansteuerungsvorrichtung 50.1 auch die abwechselnde Durchführung der Empfangsphase und/oder der Übertragungsphase unterbrochen werden, also eine weitere Unterbrechungsphase eingeführt werden. Diese dient z. B. zum Pausieren der Ausgabe eines Ausgangssignals A und/oder der Übertragung des Empfangssignals, um bspw. den Energieverbrauch zu reduzieren.

Das Prinzip-Schaltbild gemäß Figur 2 macht deutlich, dass insbesondere durch die beschriebene Umschaltung des Schalterelements S ohne weitere Maßnahmen ein Rechtecksignal zur Ansteuerung und/oder Auswertung des Sensorelements 20.1 bewirkt wird. Dieses weist entsprechend ein sehr breites Frequenzspektrum auf. Ein solches ungünstiges Frequenzspektrum kann ohne weitere Maßnahmen dazu führen, dass eine störende elektromagnetische Abstrahlung (Emission) durch das Sensorelement 20.1 in die Umgebung des Fahrzeuges 1 erfolgt, und insbesondere in Frequenzbereichen, welche Störauswirkungen auf andere Funksignale oder dergleichen haben können.

Daher kann es als Maßnahme im Rahmen der Erfindung vorgesehen sein, dass eine phasenabhängige und/oder frequenzabhängige Übertragung und/oder Veränderung wenigstens eines Signals zur Ansteuerung und/oder Auswertung durchgeführt wird. So kann z. B. zur Ansteuerung (d. h. zur Übertragung an das Sensorelement 20.1 und/oder zur Aufladung und/oder zum Betreiben des Sensorelements 20.1) ein Signal, nämlich das Ausgangssignal A, direkt an einem Ausgang 30.2 einer Übertragungsanordnung 30 ausgegeben und/oder erzeugt werden, wobei über eine Signalformung und/oder Filterung die Breite des Frequenzspektrums des Signals, insbesondere die Oberschwingungen, und damit die Störauswirkung reduziert werden können. Als weiteres Signal kann für die Auswertung auch das Empfangssignal von dem Sensorelement 20.1 durch die phasen- und/oder frequenzabhängige Übertragung bzw. Veränderung beeinflusst werden, bspw. durch eine Verbindung der Übertragungsanordnung 30 mit der Halteanordnung 50.4, um hierdurch den Empfang des Empfangssignals zu steuern.

Von Vorteil ist es außerdem, wenn das Signal und/oder die Signalformung durch die Ansteuerungsvorrichtung 50.1 und/oder durch eine mit der Ansteuerungsvorrichtung 50.1 verbundene und/oder darin integrierte Ansteuerungsanordnung 50.6 beeinflusst werden. Diese können mit einem Eingang 30.1 der Übertragungsanordnung 30 verbunden sein, um ein Eingangssignal E (insbesondere Ansteuerungssignal E) für die Übertragungsanordnung 30 an dem Eingang 30.1 bereitzustellen. Auf diese Weise kann die Übertragungsanordnung 30 zwischen der Ansteuerungsvorrichtung 50.1 und dem Sensorelement 20.1 zwischengeschaltet sein, um die frequenz- und/oder phasenabhängige Übertragung bzw. Veränderung beim Eingangssignal E vorzunehmen. Diese erfolgt dabei insbesondere derart als eine vorteilhafte Frequenzfilterung, dass die störenden Frequenzen beim Eingangssignal E überwiegend herausgefiltert werden. Hierzu kann das Eingangssignal E, wenn es am Eingang 30.1 der Übertragungsanordnung 30 anliegt, gefiltert und als Ausgangssignal A am Ausgang 30.2 ausgegeben werden. Auch kann in Abhängigkeit von diesem übertragenen / veränderten (insbesondere gefilterten) Eingangssignal E durch die Übertragungsanordnung 30 ein geführtes Ausgangssignal A ausgegeben werden. Damit wird gewährleistet, dass die Form des übertragenen bzw. veränderten bzw. gefilterten Signals - und damit das gefilterte Frequenzspektrum - auch an dem Sensorelement 20.1 beibehalten wird. Unter "geführt" kann insbesondere verstanden werden, dass das Ausgangssignal A aktiv in Abhängigkeit von dem übertragenen bzw. veränderten bzw. gefilterten Eingangssignal E erzeugt und an dem Sensorelement 20.1 angelegt wird, z. B. durch die Nutzung eines Operationsverstärkers OP.

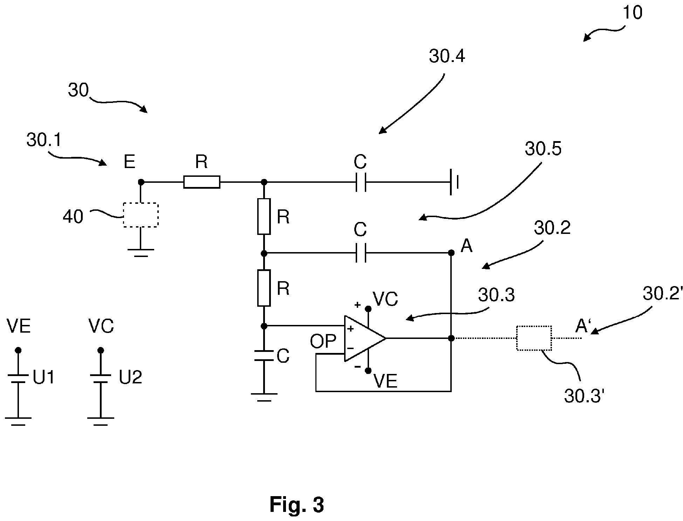

Wie Figur 2 und mit weiteren Einzelheiten auch Figur 6 schematisch zu entnehmen ist, kann die Übertragungsanordnung 30 auch mit einem Eingang der Halteanordnung 50.4 verbunden sein. Dabei umfasst die Halteanordnung 50.4 z. B. einen Integrator. Beispielhaft kann daher vorgesehen sein, dass ein Eingang der Übertragungsanordnung 30, insbesondere ein nicht invertierter Eingang "+" des Operationsverstärkers OP der Übertragungsanordnung 30, mit einem Eingang des Integrators, bevorzugt einem (nicht invertierten) Eingang "+" eines weiteren Operationsverstärkers OP' des Integrators, verbunden ist. Vorzugsweise ist diese Verbindung dafür ausgeführt, dass die Halteanordnung 50.4 in Abhängigkeit von der frequenz- und/oder phasenabhängigen Übertragung und/oder Veränderung durch die Übertragungsanordnung 30 das Empfangssignal von dem Sensorelement 20.1 über den Receive-Pfad r empfängt. Hierzu kann ein von der Übertragungsanordnung 30 bereitgestelltes Signal (z. B. am Eingang "+" des Operationsverstärkers OP in Figur 3 und 6), welches die frequenz- und/oder phasenabhängige Veränderung durch die Filterung aufweist, z. B. die Funktion der Halteanordnung 50.4 bzw. des Integrators beeinflussen. Wenn die Verbindung mit dem Eingang des Integrators erfolgt, kann dieses bereitgestellte Signal als eine Art Referenz für die Integration aufgefasst werden (z. B. durch die Verbindung mit dem nicht-invertierten Operationsverstärkereingang des Integrators beeinflusst das bereitgestellte Signal die Differenzspannung dieses weiteren Operationsverstärkers OP' des Integrators und ggf. über eine Rückkopplung bei dem Operationsverstärker OP' somit auch das Empfangssignal). Die Verschaltung der in Figur 6 gezeigten Bauelemente kann dabei derjenigen in Figur 2 und 3 entsprechen, wie durch gestrichelte Verbindungslinien verdeutlicht wird.

In Figur 3 ist die Übertragungsanordnung 30 mit weiteren Einzelheiten gezeigt. Die Schaltung zur Erzeugung des Eingangssignals E, also insbesondere die Kontrollvorrichtung 50, vorzugsweise die Ansteuerungsvorrichtung 50.1 und/oder die Ansteuerungsanordnung 50.6, wird schematisch durch eine Eingangssignalquelle 40 repräsentiert. Diese ist in der Lage, ein elektrisches Eingangssignal E, wie zumindest ein im Wesentlichen als Rechtecksignal ausgeführtes oder darauf basierendes Eingangssignal E, zu erzeugen. Auch kann die Ansteuerungsanordnung 50.6 ggf. eine weitergehende Signalformung des Eingangssignals E durchführen, z. B. über zuschaltbare Widerstände, um das Eingangssignal E zu formen. Hierzu kann die Ansteuerungsanordnung 50.6 auch durch die Ansteuerungsvorrichtung 50.1 angesteuert werden, um die Signalformung z. B. kontrolliert durch das Anpassungsmittel 50.3 durchzuführen. Der Eingang 30.1 ist elektrisch mit wenigstens einer ersten Filterkomponente 30.4, insbesondere einem RC-Glied, und/oder einer zweiten Filterkomponente 30.5, insbesondere weiteren Widerständen R und/oder Kondensatoren C zur Ausbildung eines Sallen-Key-Filters, verbunden. Die erste Filterkomponente 30.4 umfasst z. B. einen (ggf. einzigen) Widerstand R und einen (ggf. einzigen) Kondensator C. Bevorzugt kann durch die Verschaltung der beiden Filterkomponenten 30.4, 30.5 durch die Übertragungsanordnung 30 insgesamt ein Filter dritter Ordnung bereitgestellt werden. Die Nutzung eines Operationsverstärkers OP ermöglicht ferner die Ausbildung als aktives Filter, vorzugsweise Sallen-Key-Filter.

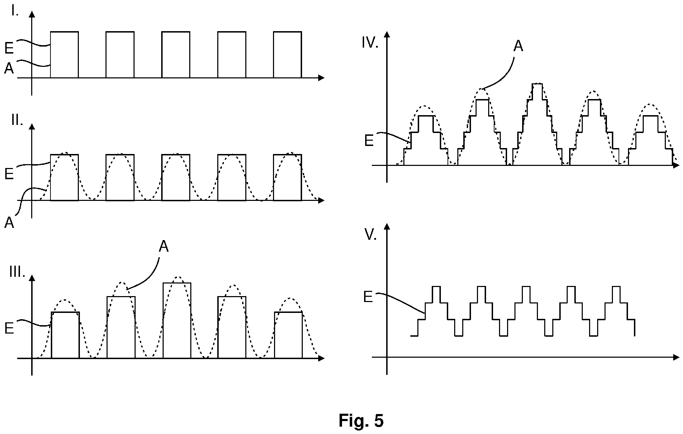

In Figur 2 ist die Ansteuerungsvorrichtung 50.1 schematisch über eine Leitung mit der Ansteuerungsanordnung 50.6 verbunden. Dies dient der vereinfachten Darstellung des Schaltbildes, wobei die Leitung ggf. auch als mehrere Leitungen verstanden werden kann, welche jeweilige Ausgänge der Ansteuerungsvorrichtung 50.1 mit jeweiligen Widerständen der Ansteuerungsanordnung 50.6 verbinden. So kann die Ansteuerungsvorrichtung 50.1 z. B. über wenigstens eine oder zwei oder drei oder vier separate elektrische Leitungen mit der Ansteuerungsanordnung 50.6 verbunden sein, insbesondere um über die Leitungen jeweils wenigstens einen Widerstand der Ansteuerungsanordnung 50.6 anzusteuern. Ferner können die Leitungen bspw. jeweils einen Ausgang der Ansteuerungsvorrichtung 50.1 mit wenigstens einem Widerstand der Ansteuerungsanordnung 50.6 verbinden, und vorzugsweise den jeweiligen Ausgang dann über den jeweiligen Widerstand / die jeweiligen Widerstände mit dem Eingang 30.1 elektrisch verbinden. Bspw. umfasst die Ansteuerungsanordnung 50.6 wenigstens zwei oder drei oder vier Widerstände, welche jeweils mit einem ersten Anschluss über eine jeweilige Leitung mit der Ansteuerungsvorrichtung 50.1 und mit einem zweiten Anschluss mit dem Eingang 30.1 verbunden sind. Da es sich hierbei um verschiedene Leitungen und Ausgänge der Ansteuerungsvorrichtung 50.1 handelt, können die Widerstände einzeln und/oder unabhängig voneinander angesteuert werden, um das Eingangssignal E am Eingang 30.1 geformt bereitzustellen. Es wird in anderen Worten ein programmierbarer Spannungsteiler durch die Ansteuerungsanordnung 50.6 gebildet. Dies ermöglicht eine Formung des Eingangssignals E, wie es zu Figur 5 näher erläutert wird.

Es ist erkennbar, dass die Filterkomponenten 30.4, 30.5 elektrisch mit einer Quellenvorrichtung 30.3, insbesondere einer Strom- und/oder Spannungsquellenvorrichtung 30.3, verbunden sein können. Im in Figur 3 gezeigten Beispiel ist die Quellenvorrichtung 30.3 als der Operationsverstärker OP ausgeführt, welcher im Sinne einer Sallen-Key-Filter-Konfiguration mit den Filterkomponenten 30.4, 30.5 verschaltet ist. Entsprechend kann der Operationsverstärker OP und/oder die Quellenvorrichtung 30.3 ggf. auch als eine weitere Filterkomponente verstanden werden. Die Quellenvorrichtung 30.3 bewirkt anhand des durch die Filterkomponenten 30.4, 30.5 gefilterten Eingangssignals E eine Ausgabe eines Ausgangssignals A am Ausgang 30.2. Zur aktiven Führung des Ausgangssignals A ist die Quellenvorrichtung 30.3 mit einer Versorgungsspannung verbunden. Dargestellt sind dabei beispielhaft eine erste Spannung U1 zur Bereitstellung eines ersten Versorgungspotentials VE und eine zweite Spannung U2 zur Bereitstellung eines zweiten Versorgungspotentials VC, wobei die Spannungen z. B. betragsgleich und unterschiedlicher Polarität sind. U1 beträgt bspw. -5 V und U2 bspw. +5 V. Durch eine entsprechende Auslegung der Bauelemente kann dabei eine Übertragungsanordnung 30 bereitgestellt werden, welche die Filtereigenschaften eines aktiven Tiefpassfilters aufweist, insbesondere dritter Ordnung und/oder mit einer Abschwächung in Höhe von -20 dB bei 1 MHz und/oder einer Grenzfrequenz von 470 kHz. In anderen Worten kann eine Oberwellenunterdrückung von mindestens -20 dB bereitgestellt werden. Das Filter eignet sich dabei besonders für eine Arbeitsfrequenz der Sensorvorrichtung 20 in Höhe von (im Wesentlichen) 333 kHz, welche durch die Frequenz der Umschaltungen zwischen den Empfangsphasen und/oder Übertragungsphasen bestimmt wird. Bspw. wird die Arbeitsfrequenz (oder auch weitere Arbeitsfrequenzen) also von der Umschaltfrequenz des Schalterelements S bestimmt oder entspricht dieser. Insbesondere können Oberschwingungen ab der 2. Harmonischen oder 3. Harmonischen effektiv unterdrückt werden.

Alternativ kann ggf. auch auf die Filterkomponenten 30.4, 30.5 verzichtet werden, sodass z. B. die Übertragungsanordnung 30 lediglich die gesteuerte Quellenvorrichtung 30 aufweist, um das Eingangssignal E im Wesentlichen unverändert zu übertragen und dann als Ausgangssignal A (z. B. als Rechtecksignal) ohne Filterung auszugeben. Ferner kann die Übertragungsanordnung 30 auch die Filtereigenschaften eines Allpass oder dergleichen aufweisen.

Eine weitere Alternativ und/oder Ergänzung der erfindungsgemäßen Anordnung 10 ist in Figur 3 in gestrichelten Linien gezeigt. Dabei kann am Ausgang 30.2, vorzugsweise an dem Operationsverstärker OP und/oder der Quellenvorrichtung 30.3 und/oder der wenigstens einen Filterkomponente 30.4, 30.5, eine Verbindung zu einer weiteren Quellenvorrichtung 30.3' vorgesehen sein, um einen alternativen Ausgang 30.2' bereitzustellen. Diese Ausbildung ist dabei nur optional, um bspw. eine Stromquelle und/oder einen Wandler als weitere Quellenvorrichtung 30.3' zu nutzen, um so in alternativer Weise ein geführtes Ausgangssignal A' ausgegeben. Diese Ausbildung mit der weiteren Quellenvorrichtung 30.3' kann zusätzlich zur gezeigten Ausbildung mit dem Operationsverstärker OP genutzt werden, oder auch die Quellenvorrichtung 30.3 ersetzen. Im letzteren Falle kann das Filter, welches durch die Filterkomponenten 30.4, 30.5 gebildet ist, auch als passives Filter ausgeführt sein und/oder die weitere Quellenvorrichtung 30.3' ebenfalls eine Filterkomponente zur Ausbildung eines aktiven Filters ausbilden. Grundsätzlich kann es sich daher bei dem Ausgangssignal A bzw. A' um eine zwangsgeführte Sensorspannung oder einen zwangsgeführten Sensorstrom handeln.

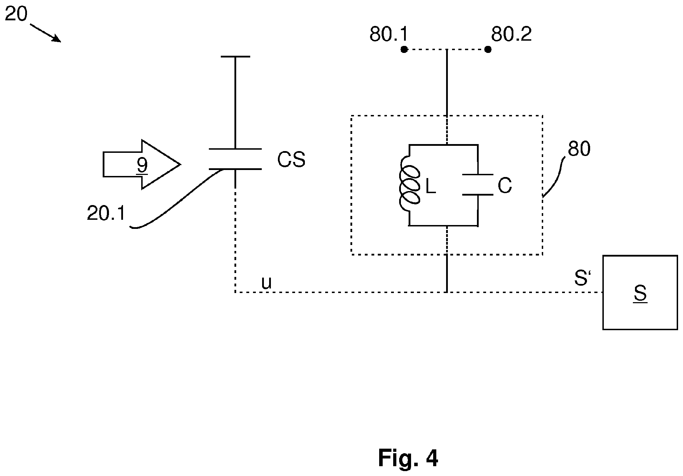

In Figur 4 ist der Übertragungsweg eines Signals S' zwischen dem Schalterelement S und dem wenigstens einen Sensorelement 20.1 gezeigt. Innerhalb dieses Übertragungswegs entlang eines Übertragungspfads u können noch weitere elektronische Elemente angeordnet sein, was durch eine gestrichelte Linie des Übertragungspfads u angedeutet ist. Diese weiteren Elemente können bspw. eine weitere Filterung des Signals S' bewirken. Das Schalterelement S verbindet je nach Schalterstellung (Schaltzustand) diesen Übertragungsweg mit dem Receive-Pfad r zur Auswertung oder dem Transmit-Pfad t zur Ansteuerung. In einer ersten Schalterstellung des Schalterelements S kann somit das Signal S' dem Ausgangssignal A entsprechen, welches von dem Ausgang 30.2 der Übertragungsanordnung 30 zum Sensorelement 20.1 übertragen wird. In einer zweiten Schalterstellung des Schalterelements S kann das Signal S' hingegen einem Empfangssignal entsprechen und zur Halteanordnung 50.4 über den Receive-Pfad r übertragen werden. Im letzteren Fall ist das Signal S spezifisch für die Erfassung, und kann z. B. durch die Kontrollvorrichtung 50 ausgewertet werden, um eine Aktivierungshandlung zu detektieren.

Wie weiter in Figur 4 dargestellt ist, kann eine Vorfilteranordnung 80, insbesondere ein Preselector 80, vorzugsweise in der Form eines Saugkreises und/oder eines Bandpassfilters oder eines Bandstoppfilters (Bandsperre), genutzt werden. Dadurch können störende Frequenzen des Signals S' herausgefiltert werden, welche ggf. durch das Sensorelement 20.1 (im Sinne einer Einstrahlung bzw. Immission) eintreten. Daraus wird deutlich, dass das Sensorelement 20.1 ggf. auch als eine Art Antenne angesehen werden kann, über welche Emissionen (aus der Sensorvorrichtung 20 in die Umgebung des Fahrzeuges 1) austreten und Immissionen (aus der Umgebung in die Sensorvorrichtung 20) eintreten können. Die Ausdrücke Emissionen und Immissionen werden hierbei im Sinne störender Funksignale bzw. elektromagnetischer Strahlung verwendet. Die Vorfilteranordnung 80 kann bspw. als ein LC-Schwingkreis und/oder Saugkreis ausgeführt sein, z. B. mit zueinander parallel geschalteten Kondensator C und Spule L. Die Vorfilteranordnung 80 ist beispielhaft mit einem ersten und zweiten Anschluss 80.1, 80.2 verbunden. Vorteilhafterweise kann der erste Anschluss 80.1 die Vorfilteranordnung 80 mit einem Versorgungspotential verbinden, und/oder der zweite Anschluss 80.2 die Vorfilteranordnung 80 mit einem Massepotential verbinden. Dies hat den Vorteil, dass Signalanteile des Signals S' im unerwünschten Frequenzbereich über wenigstens einen dieser Anschlüsse geleitet, d. h. abgeführt werden können. Hierzu wird die Vorfilteranordnung 80 für diesen ggf. unerwünschten Frequenzbereich niederohmig. Für die gewünschte Frequenz kann die Vorfilteranordnung 80 hingegen hochohmig werden, sodass das Signal S' für diese Frequenz nicht durch die Vorfilteranordnung 80 geleitet wird (die Vorfilteranordnung 80 wirkt demnach als Bandpass für die gewünschte Frequenz derart, dass die Vorfilteranordnung 80 die gewünschte Frequenz nicht abführt). Im Idealfall, also einem Betrieb ausschließlich mit einem Signal S' der gewünschten Frequenz, entsteht somit kein Verlust durch diese Filterung. Die Verlustleistung kann entsprechend durch diesen Aufbau deutlich reduziert werden. Es kann darüber hinaus möglich sein, dass in dem Receive-Pfad r und dem Transmit-Pfad t jeweils ein Widerstand und/oder eine Widerstandsanordnung für die Vorfilteranordnung 80 integriert sind, wobei vorzugsweise die Widerstände und/oder die Widerstandsanordnungen (im Wesentlichen) gleich (mit gleichem Widerstandswert und/oder gleicher Größe und/oder gleicher Impedanz) ausgeführt sind. Die Widerstände und/oder die Widerstandsanordnungen können dazu ausgeführt sein, eine Übertragungsfunktion der Vorfilteranordnung 80 anzupassen.

Figur 5 zeigt verschiedene Möglichkeiten II. bis V. zur Signalformung des Eingangssignals E (durchgehende Linie) und das daraus jeweils resultierende Ausgangssignal A (gestrichelte Linie). Zur Verdeutlichung wird die Darstellung I. gezeigt, in welcher keinerlei frequenz- und/oder phasenabhängige Veränderung und/oder nur eine frequenz- und/oder phasenabhängige Übertragung des Eingangssignals E durch die Übertragungsanordnung 30 erfolgt. In Darstellung II. wird hingegen eine Filterung des Eingangssignals E durch die Übertragungsanordnung 30, also insbesondere über die Filterkomponenten, durchgeführt. Die Filterkomponenten bewirken dabei bevorzugt die Bereitstellung eines Analog-Tiefpasses, welcher die Rechteck-Form des Eingangssignals E verändert. Auf diese Weise kann ein sinusartiges Ausgangssignal A bereitgestellt werden. Darstellung III. zeigt ein Beispiel für eine weitergehende Signalformung, bei welcher neben der Filterung durch die Filterkomponenten der Übertragungsanordnung 30 auch eine Modulation (insbesondere als ein "Verschleifen") durch die Ansteuerungsvorrichtung 50.1 und/oder die Ansteuerungsanordnung 50.6 bewirkt wird. Das Eingangssignal E weicht hierbei von der ursprünglichen Rechteck-Form ab und zeigt aufgrund der Modulation eine zeitlich auf- und wieder absteigende Amplitude einzelner Pulse. Diese weitergehende Signalformung kann bspw. direkt bei der Erzeugung des Eingangssignals E durch die Ansteuerungsvorrichtung 50.1 bewirkt werden. Eine Weiterentwicklung zeigt Darstellung IV., bei welcher zusätzlich zur Modulation gemäß III. eine weitere Modulation zum Einsatz kommt. Dabei weist das Eingangssignal E eine Stufenform auf, welche die Filterung durch die Übertragungsanordnung 30 begünstigen kann. In anderen Worten kann gemäß Darstellung III. die Ansteuerungsanordnung 50.6 und/oder eine Ansteuerungsvorrichtung 50.1 dazu ausgeführt sein, die Formung des Eingangssignals E durch Erzeugung eines rechteckartigen Signals mit zeitlich aufeinanderfolgenden Pulsen durchzuführen, wobei sich die Pulsamplituden unterschiedlicher Pulse zeitlich verändern, vorzugsweise mit einer zeitlich auf- und wieder absteigenden Amplitude (insbesondere innerhalb eines Bursts), wobei vorzugsweise die Pulsamplitude einzelner Pulse (im Wesentlichen) über die Pulsbreite konstant bleibt. Dagegen kann in Darstellung IV. zusätzlich die Pulsamplitude einzelner Pulse sich ebenfalls innerhalb der Pulsbreite zeitlich verändern, vorzugsweise eine Stufenform aufweisen. Auf diese Weise kann besonders zuverlässig ein sinusartiges Ausgangssignal A erzeugt werden. Ein besonders vorteilhaftes Beispiel für ein Eingangssignal E ist in Darstellung V. gezeigt. Dieses Signal kann beispielweise durch eine Signalformung erhalten werden, welche durch die Ansteuerungsvorrichtung 50.1 und/oder die Ansteuerungsanordnung 50.6 bereitgestellt wird. Hierzu ist die Ansteuerungsanordnung 50.6 z. B. als ein programmierbarer Spannungsteiler ausgeführt. Die dargestellte Form weist mehrere zeitlich aufeinanderfolgende rechteckartige Pulse auf, welche sich hinsichtlich ihrer Pulsamplitude voneinander unterscheiden. Hierzu kann für die Ansteuerungsanordnung 50.6 über die verschiedenen Leitungen, welche jeweils mit wenigstens einem Widerstand der Ansteuerungsanordnung 50.6 verbunden sind, durch die Ansteuerungsvorrichtung 50.1 ein Ansteuerungssignal ausgegeben werden. Dieses ist bspw. in der Art einer Pulsweitenmodulation oder dergleichen ausgeführt, und unterscheidet sich für unterschiedliche Leitungen. Die Widerstände der unterschiedlichen Leitungen sind bspw. unterschiedlich groß. Auf diese Weise kann das Eingangssignal E sehr genau mit der gewünschten Form erzeugt werden. Durch die Symmetrie der Form, insbesondere der gleichartigen an- und absteigenden Pulsfolge und/oder dem gleichbleibenden Absolutwert der Amplitudendifferenz für unterschiedliche Pulse, kann ein besonders vorteilhaftes Spektrum erzeugt werden. Insbesondere kann hierdurch die 3. Harmonische im Spektrum des Eingangssignals E (ggf. vollständig) eliminiert werden.

Die voranstehende Erläuterung der Ausführungsformen beschreibt die vorliegende Erfindung ausschließlich im Rahmen von Beispielen.

### Bezugszeichenliste

- 1: Fahrzeug
- 2: Heckklappe
- 3: Stoßfänger
- 4: Türgriff
- 8: Benutzer
- 9: Körperteil, Aktivierungsmittel

- 10: Anordnung, Schaltungsanordnung

- 20: Sensorvorrichtung
- 20.1: Sensorelektrode, Sensorelement
- 20.2: Massepotential

- 30: Übertragungsanordnung
- 30.1: Eingang
- 30.2: Ausgang
- 30.3: Quellenvorrichtung, Spannungsquellenvorrichtung
- 30.4: erste Filterkomponente, RC-Glied für Tiefpass 1. Ordnung
- 30.5: zweite Filterkomponente, weitere Anordnung für Tiefpass 2. Ordnung

- 40: Eingangssignalquelle, digitale Signalerzeugung

- 50: Kontrollvorrichtung
- 50.1: Ansteuerungsvorrichtung, Mikrocontroller
- 50.2: Analog-Digital-Wandler
- 50.3: Anpassungsmittel, Software
- 50.4: Halteanordnung
- 50.5: Tiefpass-Filter
- 50.6: Ansteuerungsanordnung
- 50.7: weiteres Kontrollelement

- 60: Schaltvorrichtung

- 80: Preselector, Vorfilter
- 80.1: erster Anschluss, Versorgungsanschluss
- 80.2: zweiter Anschluss, Masseanschluss

- r: Receive-Pfad
- t: Transmit-Pfad
- A: Ausgangssignal
- C: Kondensator
- CH: Haltekapazität
- CS: Sensorkapazität
- E: Eingangssignal
- OP: Operationsverstärker
- R: Widerstand
- S: Schalterelement
- U1: erste Spannung
- U2: zweite Spannung
- VC: Versorgungsspannung, zweites Potential
- VE: Versorgungsspannung, erstes Potential

## Patentansprüche

1. Anordnung (10) für eine kapazitive Sensorvorrichtung (20) eines Fahrzeuges (1), insbesondere zur Ansteuerung und/oder Auswertung bei der kapazitiven Sensorvorrichtung (20) zur Detektion einer Aktivierungshandlung beim Fahrzeug (1), aufweisend:
- wenigstens eine Sensorelektrode (20.1) zur Erfassung einer Veränderung in einer Umgebung des Fahrzeuges (1),
- eine Übertragungsanordnung (30) zur Bereitstellung eines Ausgangssignals (A) durch eine frequenzabhängige Veränderung eines elektrischen Eingangssignals (E) der Übertragungsanordnung (30),
- einen Ausgang (30.2) der Übertragungsanordnung (30), welcher elektrisch mit der Sensorelektrode (20.1) verbunden ist, um die Sensorelektrode (20.1) mit dem Ausgangssignal (A) zu betreiben,
wobei die Übertragungsanordnung (30) wenigstens eine Filterkomponente (30.4, 30.5) aufweist, um die frequenzabhängige Veränderung durchzuführen,
wobei eine Eingangssignalquelle (40) mit einem Eingang (30.1) der Übertragungsanordnung (30) verbunden ist, um das Eingangssignal (E) als ein auf einem Rechtecksignal basierende Signal am Eingang (30.1) bereitzustellen, welches durch Signalformung aktiv verändert ist durch ein Verschleifen der Flanken des Rechtecksignals und durch eine zeitlich veränderliche Amplitude, um die frequenzabhängige Veränderung, vorzugsweise eine Oberwellenunterdrückung, der Übertragungsanordnung (30) zu unterstützen.

2. Anordnung (10) nach Anspruch 1,
**dadurch gekennzeichnet,**
**dass** die Übertragungsanordnung (30) durch die wenigstens eine Filterkomponente (30.4, 30.5) als ein aktives elektronisches Filter, vorzugsweise als ein Sallen-Key-Filter, ausgebildet ist,
und/oder dass die Übertragungsanordnung (30) mittels der wenigstens einen Filterkomponente (30.4, 30.5) ein Tiefpass-Filter ausbildet, um das Eingangssignal (E) derart zu filtern, dass bei dem Betrieb der Sensorelektrode (20.1) eine Abstrahlung in einem störenden Frequenzbereich, vorzugsweise ab einer zweiten Harmonischen des Eingangssignals (E), zumindest reduziert wird.

3. Anordnung (10) nach einem der vorhergehenden Ansprüche,
**dadurch gekennzeichnet,**
**dass** die wenigstens eine Filterkomponente (30.4, 30.5) eine erste Filterkomponente (30.4), insbesondere zur Ausbildung eines RC-Tiefpass-Filters, und eine zweite Filterkomponente (30.5), insbesondere zur Ausbildung eines Sallen-Key-Filters, umfasst, wobei die Filterkomponenten (30.4, 30.5) miteinander verschaltet sind, um gemeinsam die frequenzabhängige Veränderung des Eingangssignals (E) durchzuführen.

4. Anordnung (10) nach einem der vorhergehenden Ansprüche,
**dadurch gekennzeichnet,**
**dass** das Ausgangssignal (A) in Abhängigkeit von der frequenzabhängigen Veränderung des Eingangssignals (E) dadurch bereitstellbar ist, dass die wenigstens eine Filterkomponente (30.4, 30.5) zwischen dem Ausgang (30.2) und einem Eingang (30.1) der Übertragungsanordnung (30) verschaltet ist.

5. Anordnung (10) nach einem der vorhergehenden Ansprüche,
**dadurch gekennzeichnet,**
**dass** eine Ansteuerungsvorrichtung (50.1) als Teil einer Eingangssignalquelle (40) vorgesehen ist, um das Eingangssignal (E), vorzugsweise über einen Digital-Analog-Wandler, zu erzeugen.

6. Anordnung (10) nach einem der vorhergehenden Ansprüche,
**dadurch gekennzeichnet,**
**dass** zur Signalformung des Eingangssignals (E) eine Ansteuerungsanordnung (50.6) als Teil einer Eingangssignalquelle (40) vorgesehen ist, welche zwischen einem Eingang (30.1) der Übertragungsanordnung (30) und einer Ansteuerungsvorrichtung (50.1) verschaltet ist, um ein durch die Ansteuerungsvorrichtung (50.1) erzeugtes Eingangssignal (E) durch die Signalformung zu verändern und an dem Eingang (30.1) der Übertragungsanordnung (30) anzulegen,
und/oder dass eine Ansteuerungsvorrichtung (50.1) als Teil einer Eingangssignalquelle (40) dazu ausgeführt ist, eine Ansteuerungsanordnung (50.6) derart anzusteuern, dass das Eingangssignal (E) einem rechteckartigen Signal entspricht, welches zwischen ersten und zweiten Werten wechselt, wobei die ersten und zweiten Werte an- und wieder absteigend sich zeitlich verändern.

7. Anordnung (10) nach einem der vorhergehenden Ansprüche,
**dadurch gekennzeichnet,**
**dass** ein Schalterelement (S) zwischen dem Ausgang (30.2) der Übertragungsanordnung (30) und der Sensorelektrode (20.1) verschaltet ist, um gesteuert, bevorzugt wiederholt und/oder getaktet, einen Receive-Pfad (r) und einen Transmit-Pfad (t) abwechselnd mit der Sensorelektrode (20.1) zu verbinden, wobei der Ausgang (30.2) mit dem Transmit-Pfad (t) verbunden ist, und eine Halteanordnung (50.4) zur Auswertung bei der Sensorvorrichtung (20) mit dem Receive-Pfad (r) verbunden ist.

8. Anordnung (10) nach einem der vorhergehenden Ansprüche,
**dadurch gekennzeichnet,**
**dass** eine Halteanordnung (50.4) zur Auswertung bei der Sensorvorrichtung (20) in einem Receive-Pfad (r) integriert ist, um nach einer Aufladung der Sensorelektrode (20.1) durch das Ausgangssignal (A) ein Empfangssignal in Abhängigkeit von der in der Sensorelektrode (20.1) gespeicherten Ladung und/oder in Abhängigkeit von einer veränderlichen Sensorkapazität (CS) der Sensorvorrichtung (20) zu empfangen, wobei die Sensorelektrode (20.1) zur Bereitstellung der Sensorkapazität (CS) ausgeführt ist,
und/oder dass eine Halteanordnung (50.4) zur Auswertung einer veränderlichen Sensorkapazität (CS) vorgesehen ist, um die Veränderung in der Umgebung des Fahrzeuges (1) anhand dieser Auswertung zu detektieren, wobei die Halteanordnung (50.4) als Integrator ausgebildet ist, um eine Ladungsakkumulation anhand einer in der Sensorelektrode (20.1) gespeicherten Ladung durchzuführen.

9. Anordnung (10) nach einem der vorhergehenden Ansprüche,
**dadurch gekennzeichnet,**
**dass** die Sensorelektrode (20.1) dazu ausgeführt ist, in elektrischer Wirkverbindung mit der Umgebung des Fahrzeuges (1) anordenbar zu sein, vorzugsweise in einem Stoßfänger (3) oder in einem Türgriff (4) des Fahrzeuges (1), sodass bei dem Betrieb der Sensorelektrode (20.1) ein elektrisches Feld in der Umgebung entsteht, um eine veränderliche Sensorkapazität (CS) in Abhängigkeit von der Umgebung bereitzustellen.

10. Anordnung (10) nach einem der vorhergehenden Ansprüche,
**dadurch gekennzeichnet,**
**dass** die Übertragungsanordnung (30) mit einer Halteanordnung (50.4) verbunden ist, um ein Empfangssignal von der Sensorelektrode (20.1) in Abhängigkeit von der frequenzabhängigen Veränderung bei der Halteanordnung (50.4) zu empfangen, vorzugsweise um die frequenzabhängige Veränderung auch für das Empfangssignal für die Auswertung bei der Sensorvorrichtung (20) bereitzustellen,
und/oder dass die Übertragungsanordnung (30) ein Filter mit Tiefpass-Eigenschaft ausbildet, welches eine Grenzfrequenz in einem Bereich von 100 kHz bis 800 kHz, vorzugsweise 200 kHz bis 600 kHz, bevorzugt 400 kHz bis 550 kHz, besonders bevorzugt 470 kHz aufweist.

11. Anordnung (10) nach einem der vorhergehenden Ansprüche,
**dadurch gekennzeichnet,**
**dass** ein Operationsverstärkereingang der Übertragungsanordnung (30) mit einem Integratoreingang der Halteanordnung (50.4) verbunden ist, um ein Empfangssignal von der Sensorelektrode (20.1) in Abhängigkeit von der frequenzabhängigen Veränderung zu empfangen, sodass die frequenzabhängige Veränderung sowohl für das Empfangssignal in einem Receive-Pfad (r) als auch für das Ausgangssignal (A) in einem Transmit-Pfad (t) bereitgestellt wird.

12. Außentürgriff (4) für ein Fahrzeug (1) mit einer Anordnung (10) nach einem der vorhergehenden Ansprüche.

13. Verfahren (10) zum Betreiben einer kapazitiven Sensorvorrichtung (20) eines Fahrzeuges (1), insbesondere zur Ansteuerung und/oder Auswertung bei der kapazitiven Sensorvorrichtung (20) zur Detektion einer Aktivierungshandlung beim Fahrzeug (1), wobei die Sensorvorrichtung (20) wenigstens eine Sensorelektrode (20.1) zur Bereitstellung einer Sensorkapazität (CS) aufweist,
**wobei die nachfolgenden Schritte durchgeführt werden:**
a) Umschalten wenigstens eines Schalterelements (S), um einen Transmit-Pfad (t) mit der Sensorelektrode (20.1) zu verbinden,
b) Erzeugen eines elektrischen Eingangssignals (E),
c) Durchführen einer frequenzabhängigen Veränderung des elektrischen Eingangssignals (E) zur Bereitstellung eines Ausgangssignals (A),
d) Ausgabe des Ausgangssignals (A) über den Transmit-Pfad (t) an der Sensorelektrode (20.1),
e) Umschalten des wenigstens einen Schalterelements (S), um einen Receive-Pfad (r) mit der Sensorelektrode (20.1) zu verbinden, und die Verbindung mit dem Transmit-Pfad (t) aufzuheben,
f) Übertragen eines Empfangssignals von der Sensorelektrode (20.1) zu einer Halteanordnung (50.4) im Receive-Pfad (r), um die Sensorkapazität (CS) auszuwerten,
wobei die kapazitive Sensorvorrichtung (20) eine Anordnung (10) nach einem der vorherigen Ansprüche betreffend eine Anordnung (10) aufweist.

14. Verfahren nach einem der vorhergehenden Verfahrensansprüche,
**dadurch gekennzeichnet,**
**dass** durch die frequenzabhängige Veränderung eine Oberwellenunterdrückung sowohl beim Ausgangssignal (A) als auch beim Empfangssignal erfolgt,
und/oder dass das Erzeugen des elektrischen Eingangssignals (E) als ein periodisches Signal wiederholt zur Bereitstellung einer Unterbrechungsphase unterbrochen wird, um die Ausgabe des Ausgangssignals (A) und insbesondere auch das Übertragen des Empfangssignals zu pausieren, vorzugsweise derart, dass das Ausgangssignal (A) als Burst-Signal ausgegeben wird.

## Claims

1. Arrangement (10) for a capacitive sensor device (20) of a vehicle (1), in particular for actuation and/or evaluation in the capacitive sensor device (20) for detecting an activation action in the vehicle (1):
- at least one sensor electrode (20.1) for detecting a change in an environment of the vehicle (1),
- a transmission arrangement (30) for providing an output signal (A) by means of a frequency-dependent change in an electrical input signal (E) of the transmission arrangement (30),
- an output (30.2) of the transmission arrangement (30), which is electrically connected to the sensor electrode (20.1) in order to operate the sensor electrode (20.1) with the output signal (A),
wherein the transmission arrangement (30) has at least one filter component (30.4, 30.5) to perform the frequency-dependent change,
wherein an input signal source (40) is connected to an input (30.1) of the transmission arrangement (30) in order to provide the input signal (E) as a signal based on a square-wave signal at the input (30.1), which is actively modified by signal shaping by grinding the edges of the square-wave signal and by a time-varying amplitude in order to support the frequency-dependent modification, preferably a harmonic suppression, of the transmission arrangement (30).

2. Arrangement (10) according to claim 1,
**characterized in that**
the transmission arrangement (30) is designed by the at least one filter component (30.4, 30.5) as an active electronic filter, preferably as a Sallen-Key filter,
and/or **in that** the transmission arrangement (30) forms a low-pass filter by means of the at least one filter component (30.4, 30.5) in order to filter the input signal (E) in such a way that, during operation of the sensor electrode (20.1), radiation in an interfering frequency range, preferably from a second harmonic of the input signal (E), is at least reduced.

3. Arrangement (10) according to one of the preceding claims,
**characterized in that**
the at least one filter component (30.4, 30.5) comprises a first filter component (30.4), in particular for forming an RC low-pass filter, and a second filter component (30.5), in particular for forming a Sallen-Key filter, the filter components (30.4, 30.5) being interconnected in order to jointly perform the frequency-dependent change in the input signal (E).

4. Arrangement (10) according to one of the preceding claims,
**characterized in that**
the output signal (A) can be provided as a function of the frequency-dependent change in the input signal (E) **in that** the at least one filter component (30.4, 30.5) is connected between the output (30.2) and an input (30.1) of the transmission arrangement (30).

5. Arrangement (10) according to one of the preceding claims,
**characterized in that**
a control device (50.1) is provided as part of an input signal source (40) in order to generate the input signal (E), preferably via a digital-to-analog converter.

6. Arrangement (10) according to one of the preceding claims,
**characterized in that**
for signal shaping of the input signal (E), a control arrangement (50.6) is provided as part of an input signal source (40), which is connected between an input (30.1) of the transmission arrangement (30) and a control device (50.1) in order to change an input signal (E) generated by the control device (50.1) by means of the signal shaping and to apply it to the input (30.1) of the transmission arrangement (30),
and/or **in that** a control device (50.1) as part of an input signal source (40) is designed to control a control arrangement (50.6) in such a way that the input signal (E) corresponds to a rectangular signal which alternates between first and second values, the first and second values changing in increasing and decreasing order over time.

7. Arrangement (10) according to one of the preceding claims,
**characterized in that**
a switch element (S) is connected between the output (30.2) of the transmission arrangement (30) and the sensor electrode (20.1) in order to connect a receive path (r) and a transmit path (t) alternately to the sensor electrode (20.1), wherein the output (30.2) is connected to the transmit path (t), and a holding arrangement (50.4) for evaluation at the sensor device (20) is connected to the receive path (r).

8. Arrangement (10) according to one of the preceding claims,
**characterized in that**
a holding arrangement (50.4) for evaluation is integrated in the sensor device (20) in a receive path (r) in order to receive a receive signal as a function of the charge stored in the sensor electrode (20.1) and/or as a function of a variable sensor capacitance (CS) of the sensor device (20) after the sensor electrode (20.1) has been charged by the output signal (A), the sensor electrode (20.1) being designed to provide the sensor capacitance (CS),
and/or **in that** a holding arrangement (50.4) is provided for evaluating a variable sensor capacitance (CS) in order to detect the change in the environment of the vehicle (1) on the basis of this evaluation, the holding arrangement (50.4) being designed as an integrator in order to carry out a charge accumulation on the basis of a charge stored in the sensor electrode (20.1).

9. Arrangement (10) according to one of the preceding claims,
**characterized in that**
the sensor electrode (20.1) is designed to be arranged in electrical operative connection with the environment of the vehicle (1), preferably in a bumper (3) or in a door handle (4) of the vehicle (1), so that during operation of the sensor electrode (20.1) an electric field is generated in the environment in order to provide a variable sensor capacitance (CS) as a function of the environment.

10. Arrangement (10) according to one of the preceding claims,
**characterized in that**
the transmission arrangement (30) is connected to a holding arrangement (50.4) in order to receive a reception signal from the sensor electrode (20.1) as a function of the frequency-dependent change at the holding arrangement (50.4), preferably in order to also provide the frequency-dependent change for the reception signal for evaluation at the sensor device (20),
and/or **in that** the transmission arrangement (30) forms a filter with a low-pass characteristic which has a cut-off frequency in a range from 100 kHz to 800 kHz, preferably 200 kHz to 600 kHz, preferably 400 kHz to 550 kHz, particularly preferably 470 kHz.

11. Arrangement (10) according to one of the preceding claims,
**characterized in that**
an operational amplifier input of the transmission arrangement (30) is connected to an integrator input of the holding arrangement (50.4) in order to receive a receive signal from the sensor electrode (20.1) as a function of the frequency-dependent change, so that the frequency-dependent change is provided both for the receive signal in a receive path (r) and for the output signal (A) in a transmit path (t).

12. Exterior door handle (4) for a vehicle (1) with an arrangement (10) according to one of the preceding claims.

13. Method (10) for operating a capacitive sensor device (20) of a vehicle (1), in particular for activation and/or evaluation in the capacitive sensor device (20) for detecting an activation action in the vehicle (1), wherein the sensor device (20) has at least one sensor electrode (20.1) for providing a sensor capacitance (CS),
**wherein the following steps are carried out:**
a) Switching at least one switch element (S) to connect a transmit path (t) to the sensor electrode (20.1),
b) Generating an electrical input signal (E),
c) Performing a frequency-dependent change of the electrical input signal (E) to provide an output signal (A),
d) Output of the output signal (A) via the transmit path (t) at the sensor electrode (20.1),
e) Switching the at least one switch element (S) to connect a receive path (r) to the sensor electrode (20.1) and to disconnect the transmit path (t),
f) Transmitting a receive signal from the sensor electrode (20.1) to a holding arrangement (50.4) in the receive path (r) in order to evaluate the sensor capacitance (CS),
wherein the capacitive sensor device (20) comprises an arrangement (10) according to one of the previous claims relating to an arrangement (10).

14. Method according to one of the preceding method claims,
**characterized in that**
the frequency-dependent change results in harmonic suppression for both the output signal (A) and the received signal,
and/or that the generation of the electrical input signal (E) as a periodic signal is repeatedly interrupted to provide an interruption phase in order to pause the output of the output signal (A) and in particular also the transmission of the received signal, preferably in such a way that the output signal (A) is output as a burst signal.

## Revendications

1. Ensemble (10) pour un dispositif de détection capacitif (20) d'un véhicule (1), en particulier pour la commande et/ou l'évaluation dans le dispositif de détection capacitif (20) pour la détection d'une action d'activation dans le véhicule (1), présentant :
- au moins une électrode de détection (20.1) pour détecter une modification dans un environnement du véhicule (1),
- un dispositif de transmission (30) pour fournir un signal de sortie (A) par une variation en fonction de la fréquence d'un signal d'entrée électrique (E) du dispositif de transmission (30),
- une sortie (30.2) du dispositif de transmission (30), qui est reliée électriquement à l'électrode de détection (20.1), pour faire fonctionner l'électrode de détection (20.1) avec le signal de sortie (A),
dans lequel le dispositif de transmission (30) comporte au moins un composant de filtre (30.4, 30.5) pour effectuer la modification en fonction de la fréquence,
dans lequel une source de signal d'entrée (40) est connectée à une entrée (30.1) du dispositif de transmission (30) pour fournir le signal d'entrée (E) à l'entrée (30.1) sous la forme d'un signal basé sur un signal carré qui est activement modifié par mise en forme de signal par un bouclage des flancs du signal carré et par une amplitude variable dans le temps afin de supporter la modification en fonction de la fréquence, de préférence une suppression d'harmoniques, du dispositif de transmission (30).

2. Ensemble (10) selon la revendication 1,
**caractérisé en ce que**
le dispositif de transmission (30) est réalisé par l'au moins un composant de filtre (30.4, 30.5) comme un filtre électronique actif, de préférence comme un filtre à clé de Sallen, et/ou **en ce que** le dispositif de transmission (30) forme, au moyen de l'au moins un composant de filtre (30.4, 30.5), un filtre passe-bas pour filtrer le signal d'entrée (E) de telle sorte que, lors du fonctionnement de l'électrode de détection (20.1), un rayonnement dans une plage de fréquences perturbatrice, de préférence à partir d'un deuxième harmonique du signal d'entrée (E), soit au moins réduit.

3. Ensemble (10) selon l'une quelconque des revendications précédentes,
**caractérisé en ce que**
l'au moins un composant de filtre (30.4, 30.5) comprend un premier composant de filtre (30.4), en particulier pour la formation d'un filtre passe-bas RC, et un deuxième composant de filtre (30.5), en particulier pour la formation d'un filtre Sallen-Key, les composants de filtre (30.4, 30.5) étant connectés l'un à l'autre pour effectuer ensemble la modification en fonction de la fréquence du signal d'entrée (E).

4. Ensemble (10) selon l'une quelconque des revendications précédentes,
**caractérisé en ce que**
le signal de sortie (A) peut être mis à disposition en fonction de la variation en fonction de la fréquence du signal d'entrée (E) par le fait que l'au moins un composant de filtre (30.4, 30.5) est branché entre la sortie (30.2) et une entrée (30.1) du dispositif de transmission (30).

5. Ensemble (10) selon l'une quelconque des revendications précédentes,
**caractérisé en ce qu'**
un dispositif de commande (50.1) est prévu comme partie d'une source de signal d'entrée (40) pour générer le signal d'entrée (E), de préférence par l'intermédiaire d'un convertisseur numérique-analogique.

6. Ensemble (10) selon l'une quelconque des revendications précédentes,
**caractérisé en ce que**
pour la mise en forme du signal d'entrée (E), il est prévu un dispositif de contrôle (50.6) faisant partie d'une source de signal d'entrée (40), qui est connecté entre une entrée (30.1) du dispositif de transmission (30) et un dispositif de commande (50.1), pour modifier un signal d'entrée (E) généré par le dispositif de commande (50.1) par la mise en forme du signal et l'appliquer à l'entrée (30.1) du dispositif de transmission (30),
et/ou **en ce qu'**un dispositif de commande (50.1), en tant que partie d'une source de signal d'entrée (40), est réalisé pour commander un dispositif de contrôle (50.6) de telle sorte que le signal d'entrée (E) correspond à un signal rectangulaire qui alterne entre des premières et des deuxièmes valeurs, les premières et les deuxièmes valeurs variant dans le temps de manière croissante et décroissante.

7. Ensemble (10) selon l'une quelconque des revendications précédentes,
**caractérisé en ce que**
un élément de commutation (S) est connecté entre la sortie (30.2) du dispositif de transmission (30) et l'électrode de détection (20.1), afin de commander, de préférence de manière répétée et/ou cadencée, un chemin de réception (r) et un chemin d'émission (t) en alternance avec l'électrode de détection (20.1), la sortie (30.2) étant reliée au chemin de transmission (t), et un dispositif de maintien (50.4) étant relié au chemin de réception (r) pour l'évaluation dans le dispositif de détection (20).

8. Ensemble (10) selon l'une quelconque des revendications précédentes,
**caractérisé en ce qu'**
un dispositif de maintien (50.4) pour l'évaluation est intégré dans le dispositif de détection (20) dans un chemin de réception (r) pour recevoir, après une charge de l'électrode de détection (20.1) par le signal de sortie (A), un signal de réception en fonction de la charge stockée dans l'électrode de détection (20.1) et/ou en fonction d'une capacité de capteur (CS) variable du dispositif de détection (20), l'électrode de détection (20.1) étant réalisée pour fournir la capacité de capteur (CS),
et/ou **en ce qu'**il est prévu un dispositif de maintien (50.4) pour l'évaluation d'une capacité de capteur (CS) variable, afin de détecter la modification dans l'environnement du véhicule (1) à l'aide de cette évaluation, le dispositif de maintien (50.4) étant conçu comme un intégrateur pour effectuer une accumulation de charge à l'aide d'une charge stockée dans l'électrode de détection (20.1).

9. Ensemble (10) selon l'une quelconque des revendications précédentes,
**caractérisé en ce que**
l'électrode de détection (20.1) est réalisée de manière à pouvoir être disposée en liaison active électrique avec l'environnement du véhicule (1), de préférence dans un pare-chocs (3) ou dans une poignée de porte (4) du véhicule (1), de sorte que lors du fonctionnement de l'électrode de détection (20.1), un champ électrique est créé dans l'environnement pour fournir une capacité de capteur (CS) variable en fonction de l'environnement.

10. Ensemble (10) selon l'une quelconque des revendications précédentes,
**caractérisé en ce que**
le dispositif de transmission (30) est relié à un dispositif de maintien (50.4) pour recevoir un signal de réception de l'électrode de détection (20.1) en fonction de la variation en fonction de la fréquence au niveau du dispositif de maintien (50.4), de préférence pour mettre à disposition la variation en fonction de la fréquence également pour le signal de réception pour l'évaluation au niveau du dispositif de détection (20),
et/ou **en ce que** le dispositif de transmission (30) forme un filtre avec une propriété passe-bas, qui présente une fréquence de coupure dans une plage de 100 kHz à 800 kHz, de préférence de 200 kHz à 600 kHz, de préférence de 400 kHz à 550 kHz, de manière particulièrement préférée de 470 kHz.

11. Ensemble (10) selon l'une quelconque des revendications précédentes,
**caractérisé en ce qu'**
une entrée d'amplificateur opérationnel du dispositif de transmission (30) est reliée à une entrée d'intégrateur du dispositif de maintien (50.4) pour recevoir un signal de réception de l'électrode de détection (20.1) en fonction de la variation dépendant de la fréquence, de sorte que la variation dépendant de la fréquence est fournie à la fois pour le signal de réception dans un chemin de réception (r) et pour le signal de sortie (A) dans un chemin d'émission (t).

12. Poignée de porte extérieure (4) pour un véhicule (1) comprenant un ensemble (10) selon l'une des revendications précédentes.

13. Procédé (10) pour faire fonctionner un dispositif de détection capacitif (20) d'un véhicule (1), en particulier pour la commande et/ou l'évaluation dans le dispositif de détection capacitif (20) pour la détection d'une action d'activation dans le véhicule (1), le dispositif de détection (20) présentant au moins une électrode de détection (20.1) pour fournir une capacité de détection (CS),
**les étapes suivantes étant exécutées :**
a) commuter au moins un élément de commutation (S) pour connecter un chemin de transmission (t) à l'électrode de détection (20.1),
b) génération d'un signal d'entrée électrique (E),
c) effectuer une modification en fonction de la fréquence du signal électrique d'entrée (E) pour fournir un signal de sortie (A),
d) sortie du signal de sortie (A) via le chemin de transmission (t) sur l'électrode de détection (20.1),
e) commuter ledit au moins un élément de commutation (S) pour connecter un chemin de réception (r) à l'électrode de détection (20.1) et pour supprimer la connexion avec le chemin d'émission (t),
f) transmettre un signal de réception de l'électrode de détection (20.1) à un dispositif de maintien (50.4) dans le chemin de réception (r) pour évaluer la capacité de capteur (CS),
dans lequel le dispositif de détection capacitif (20) comprend un ensemble (10) selon l'une quelconque des revendications précédentes concernant un ensemble (10).

14. Procédé selon l'une quelconque des revendications précédentes,
**caractérisé en ce que**
grâce à la modification dépendant de la fréquence, une suppression des harmoniques a lieu aussi bien pour le signal de sortie (A) que pour le signal de réception,
et/ou **en ce que** la génération du signal d'entrée électrique (E) en tant que signal périodique est interrompue de manière répétée pour fournir une phase d'interruption afin de mettre en pause la sortie du signal de sortie (A) et en particulier également la transmission du signal de réception, de préférence de telle sorte que le signal de sortie (A) soit émis en tant que signal de salve.
